# EUROPEAN PATENT APPLICATION

(11) **EP 4 832 690 A1**
(43) Date of publication of application: **28.10.2026**
(21) Application number: 25219211.7
(22) Date of filing: 27.11.2025
(51) Int. Cl.: H10D 30/66, H10D 62/10, H10D 62/13, H10D 62/815, H10D 62/832

(54) **SEMICONDUCTOR DEVICE**

(30) Priority: 21.04.2025 KR 20250051649
(71) Applicant: Samsung Electronics Co., Ltd., Suwon-si, Gyeonggi-do 16677 (KR)
(72) Inventor: KIM, Jonghak, Suwon-si (KR); KIM, Youngwoo, Suwon-si (KR); KIM, Jeongmin, Suwon-si (KR); YANG, Minji, Suwon-si (KR)
(74) Representative: Marks & Clerk LLP

(57) **Abstract**

A semiconductor device includes a first semiconductor layer having a first conductivity type, at least one unit superlattice structure stacked on the first semiconductor layer, a second semiconductor layer on the unit superlattice structure, a doped well region having a second conductivity type in the second semiconductor layer, a first doped layer having the first conductivity type in the doped well region, a gate electrode adjacent to the doped well region, a gate insulating layer between the doped well region and the gate electrode, a first electrode on the first doped layer, and a second electrode below the first semiconductor layer. The unit superlattice structure includes a first superlattice layer and a second superlattice layer on the first superlattice layer, and an energy band gap of the first superlattice layer is different from an energy band gap of the first semiconductor layer.

## Description

### BACKGROUND

In modern society, semiconductor devices are closely related to daily life. In particular, the importance of power semiconductor devices used in various fields such as transportation including electric vehicles, railways, and electric trams, renewable energy systems such as solar power generation and wind power generation, and mobile devices is gradually increasing. A power semiconductor device is a semiconductor device used to handle high voltage or high current, performing functions such as power conversion and control in large-scale power systems or high-output electronic devices. A power semiconductor device has the capability and durability to handle high power, may deal with a large amount of current, and may withstand high voltage. For example, a power semiconductor device may handle voltages from several hundred volts to several thousand volts, and currents from several tens of amperes to several thousand amperes. A power semiconductor device may minimize power loss to improve the efficiency of electrical energy. In addition, the power semiconductor device may be stably operated even in environments such as high temperatures.

Such power semiconductor devices may be classified according to the material, and, for example, there are SiC power semiconductor devices and GaN power semiconductor devices. By manufacturing a power semiconductor device using SiC or GaN instead of the conventional silicon wafer (Si wafer), it may be possible to compensate for the shortcomings of silicon having unstable characteristics at high temperatures. The SiC power semiconductor device is resistant to high temperatures and has low power loss, and may be suitable for electric vehicles, renewable energy systems, and the like.

### SUMMARY

The present disclosure relates to a semiconductor device.

Aspects of the present disclosure may provide a semiconductor device in which reliability may be enhanced.

A semiconductor device according to one implementation may include a first semiconductor layer having a first conductivity type, at least one unit superlattice structure stacked on the first semiconductor layer, a second semiconductor layer on the at least one unit superlattice structure, a doped well region having a second conductivity type in the second semiconductor layer, a first doped layer having the first conductivity type in the doped well region, a gate electrode adjacent to the doped well region, a gate insulating layer between the doped well region and the gate electrode, a first electrode on the first doped layer, and a second electrode below a lower surface of the first semiconductor layer, wherein the at least one unit superlattice structure includes: a first superlattice layer, and a second superlattice layer on the first superlattice layer, wherein an energy band gap of the first superlattice layer is different from an energy band gap of the first semiconductor layer.

A semiconductor device according to one implementation may include a first semiconductor layer having a first conductivity type, at least one unit superlattice structure stacked on the first semiconductor layer, a doped well region having a second conductivity type on the at least one unit superlattice structure, a first doped layer having the first conductivity type within the doped well region, a pillar layer having the second conductivity type within the first semiconductor layer and extending into the at least one unit superlattice structure, a gate electrode on the doped well region, a gate insulating layer between the doped well region and the gate electrode, a first electrode on the first doped layer, and a second electrode below a lower surface of the first semiconductor layer, wherein the at least one unit superlattice structure includes: a first superlattice layer, and a second superlattice layer on the first superlattice layer, wherein an energy band gap of the first superlattice layer is different from an energy band gap of the first semiconductor layer and an energy band gap of the second superlattice layer.

A semiconductor device according to an implementation may include a first semiconductor layer having a first conductivity type comprising SiC, a superlattice structure on the first semiconductor layer, the superlattice structure comprising a first superlattice layer comprising SiC or SiGeC, and a second superlattice layer comprising SiC or SiGeC, the first superlattice layer and the second superlattice layer being alternately stacked, a second semiconductor layer on the superlattice structure and comprising SiC, a doped well region having a second conductivity type in the second semiconductor layer, a first doped layer having the first conductivity type in the doped well region, a gate electrode adjacent to the doped well region, a gate insulating layer between the doped well region and the gate electrode, a first electrode on the first doped layer, and a second electrode below a lower surface of the first semiconductor layer, wherein an energy band gap of the second superlattice layer is greater than an energy band gap of the first superlattice layer.

A semiconductor device according to the implementations may improve the reliability of the semiconductor device.

A method of manufacturing a semiconductor device according to an implementation may include forming a superlattice structure including at least one unit superlattice structure by alternately forming a first superlattice layer and a second superlattice layer on a first semiconductor layer, forming a trench penetrating the superlattice structure, forming a pillar layer in the trench, forming a second semiconductor layer on the pillar layer, forming a doped well region in the second semiconductor layer, forming a first doped layer having the first conductivity type in the doped well region, forming a gate insulating layer and a gate electrode on the second semiconductor layer, and forming a first electrode on the doped well region and forming a second electrode on the lower surface of the first semiconductor layer, wherein an energy band gap of the first superlattice layer is different from an energy band gap of the first semiconductor layer.

The second superlattice layer may include SiC, and the first superlattice layer may include SiC or SiGeC.

The energy band gap of the first superlattice layer may be less than the energy band gap of the first semiconductor layer, and the energy band gap of the second superlattice layer may be greater than the energy band gap of the first superlattice layer.

The energy band gap of the second superlattice layer may be the same as the energy band gap of the first semiconductor layer and the energy band gap of the second semiconductor layer.

The second superlattice layer may include SiC, the first superlattice layer may include SiC or SiGeC, and a content (at%) of C in the first superlattice layer may be less than a content (at%) of C in the second superlattice layer.

The unit superlattice structure may further include a third superlattice layer positioned on the lower surface of the first superlattice layer, and an energy band gap of the third superlattice layer may be greater than the energy band gap of the first superlattice layer and less than the energy band gap of the second superlattice layer.

The second superlattice layer may include SiC, the third superlattice layer may include SiC or SiGeC, and a content of C (at%) in the third superlattice layer may be less than a content of C (at%) in the second superlattice layer.

The energy band gap of the first superlattice layer may be greater than the energy band gap of the first semiconductor layer, and the energy band gap of the second superlattice layer may be the same as the energy band gap of the first semiconductor layer.

The unit superlattice structure may further include a fourth superlattice layer positioned between the first superlattice layer and the second superlattice layer, and an energy band gap of the fourth superlattice layer may be less than that of the first superlattice layer and greater than that of the second superlattice layer.

The first superlattice layer and the fourth superlattice layer may include SiC, and a Si content (at%) of the fourth superlattice layer may be greater than a content of C (at%) of the first superlattice layer.

The first semiconductor layer and the second semiconductor layer may include the same material and may have the same energy band gap as each other.

At least some of the above and other features of the invention are set out in the claims.

### BRIEF DESCRIPTION OF THE DRAWINGS

FIG. 1 is a cross-sectional view showing a semiconductor device according to an implementation.
FIG. 2 is a cross-sectional view showing a superlattice structure of a semiconductor device according to an implementation.
FIG. 3 is a graph showing the content of materials constituting the first semiconductor layer and the superlattice structure of the semiconductor device according to an implementation.
FIG. 4 is a cross-sectional view showing the reverse current of a semiconductor device according to one implementation.
FIGS. 5 to 7 are graphs illustrating the content of materials constituting the first semiconductor layer and the superlattice structure in a semiconductor device according to some implementations.
FIG. 8 is a cross-sectional view showing a superlattice structure of a semiconductor device according to some implementations.
FIGS. 9 to 11 are graphs illustrating the content of materials constituting the first semiconductor layer and the superlattice structure in a semiconductor device according to some implementations.
FIG. 12 is a cross-sectional view illustrating a superlattice structure of a semiconductor device according to some implementations.
FIG. 13 and FIG. 14 are graphs showing the content of materials forming the first semiconductor layer and the superlattice structure of the semiconductor device according to some implementations.
FIGS. 15 to 19 are cross-sectional views illustrating a semiconductor device according to some implementations.
FIGS. 20 to 26 are process cross-sectional views of intermediate steps showing a method of manufacturing a semiconductor device according to an implementation.
FIGS. 27 to 31 are process cross-sectional views of intermediate steps illustrating a method of manufacturing a semiconductor device according to an implementation.

### DETAILED DESCRIPTION

Hereinafter, the present disclosure will be described in detail with reference to the accompanying drawings so that those of ordinary skill in the art to which the present disclosure pertains may easily implement various implementations of the present disclosure. The present disclosure may be implemented in various different forms and is not limited to the implementations described herein.

In order to clearly describe the present disclosure, portions irrelevant to the description have been omitted, and identical or similar components are denoted by the same reference numerals throughout the specification.

In some implementations, the size and thickness of each component shown in the drawings are arbitrarily depicted for convenience of description, and therefore, the present disclosure is not necessarily limited to what is illustrated. The thickness has been enlarged in the drawings in order to clearly illustrate various layers and regions. In the drawings, for convenience of explanation, the thicknesses of some layers and regions are illustrated in an exaggerated manner.

In some implementations, when a portion such as a layer, film, region, or plate is described as being on or above another portion, this includes not only the case where it is directly on the other portion but also the case where another portion is interposed therebetween. On the other hand, when it is stated that a certain part is "directly on" another part, it means that there is no other part in between. In some implementations, stating that something is "on" or "above" a reference part means that it is positioned above or below the reference part, and does not necessarily mean that it is positioned "on" or "above" the reference part in the direction opposite to gravity.

In some implementations, throughout the specification, when a certain part is described as "including" a certain element, this means that, unless otherwise specifically stated, it does not exclude other elements but may further include other elements.

In some implementations, throughout the specification, when referred to as "in plan view," this means when the object part is viewed from above, and when referred to as "in cross-sectional view," this means when the object part is viewed from the side of a cross-section that is vertically cut.

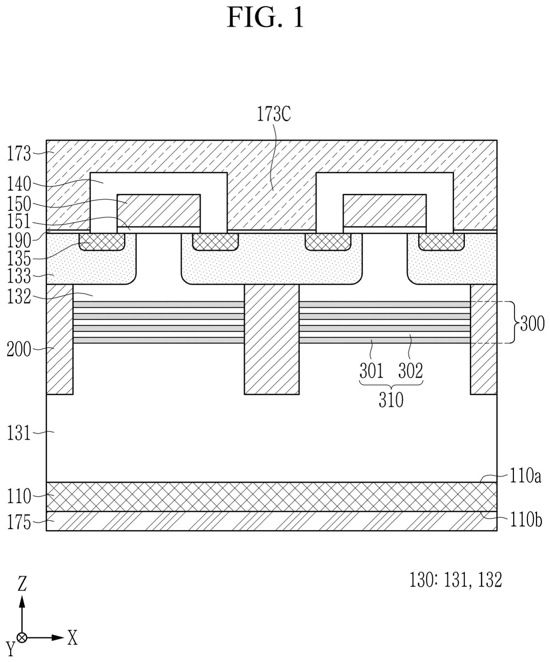

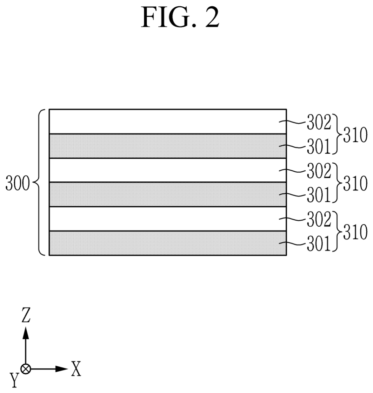

Hereinafter, a semiconductor device according to an implementation will be described with reference to FIG. 1 and FIG. 2.

FIG. 1 is a cross-sectional view showing a semiconductor device according to an implementation. FIG. 2 is a cross-sectional view showing a superlattice structure of a semiconductor device according to an implementation.

Referring to FIG. 1, a semiconductor device according to an implementation includes a substrate 110, a first semiconductor layer 131 positioned on a first surface 110a of the substrate 110, a superlattice structure 300 including at least one unit superlattice structure 310 stacked on the first semiconductor layer, a second semiconductor layer 132 positioned on the unit superlattice structure 310, a doped well region 133 having a second conductivity type positioned in the second semiconductor layer 132, a first doped layer 135 having the first conductivity type positioned in the doped well region 133, a gate electrode 150 positioned adjacent to the doped well region 133, a gate insulating layer 151 positioned between the doped well region 133 and the gate electrode 150, a first electrode 173 positioned on the first doped layer 135, and a second electrode 175 positioned on a second surface 110b of the substrate 110.

The substrate 110 may be a semiconductor substrate including SiC. For example, the substrate 110 may be formed of a 4H SiC substrate. In some cases, the substrate 110 may be formed of a 3C SiC substrate, a 6H SiC substrate, or the like. The substrate 110 may be doped with a first conductivity type impurity. For example, the first conductivity type impurity may be an n-type impurity. In other words, the substrate 110 may be doped with n-type. The substrate 110 may be heavily doped with n-type. The resistivity of the substrate 110 may be about 0.005 Ωcm or more and about 0.035 Ωcm or less. The thickness of the substrate 110 may be about 10 µm or more and about 700 µm or less. The material, doping type, doping concentration, resistivity, and thickness of the substrate 110 are not limited thereto and may be variously changed.

The substrate 110 may include a first surface 110a and a second surface 110b opposite each other. For example, the first surface 110a of the substrate 110 may be an upper surface of the substrate 110, and the second surface 110b of the substrate 110 may be a lower surface of the substrate 110.

The semiconductor layer 130 may be positioned on the first surface 110a, that is, the upper surface of the substrate 110. A lower surface of the semiconductor layer 130 may contact the first surface 110a of the substrate 110. However, the disclosure is not limited thereto, and an additional predetermined layer may be further positioned between the substrate 110 and the semiconductor layer 130. The semiconductor layer 130 of the semiconductor device according to an implementation may include a first semiconductor layer 131 positioned between the superlattice structure 300, which will be described later, and the substrate 110, and a second semiconductor layer 132 positioned on the superlattice structure 300. A superlattice structure 300 may be positioned within the semiconductor layer 130.

The first semiconductor layer 131 may be positioned on the first surface 110a, that is, the upper surface of the substrate 110. A lower surface of the first semiconductor layer 131 may contact the first surface 110a of the substrate 110. However, example implementations are not limited thereto, and an additional predetermined layer may be further positioned between the substrate 110 and the first semiconductor layer 131. The first semiconductor layer 131 may be an epitaxy layer formed by epitaxial growth from the substrate 110. The first semiconductor layer 131 may include SiC. For example, the first semiconductor layer 131 may include 4H SiC. The first semiconductor layer 131 may have a first conductivity type. The first semiconductor layer 131 may be doped with a first conductivity type impurity. For example, the first conductivity type impurity may be an n-type impurity. The first semiconductor layer 131 may be doped with a low concentration as n-type. The doping concentration of the first semiconductor layer 131 may be lower than the doping concentration of the substrate 110. The doping concentration of the first semiconductor layer 131 may be about 1*10¹⁵cm⁻³ or more and about 1*10¹⁷cm⁻³ or less. The thickness of the first semiconductor layer 131 may be about 1 µm or more and about 13 µm or less.

The superlattice structure 300 may be positioned on the first semiconductor layer 131. The superlattice structure 300 may contact the upper surface of the first semiconductor layer 131. However, example implementations are not limited thereto, and an additional predetermined layer may be further positioned between the superlattice structure 300 and the first semiconductor layer 131.

Referring further to FIG. 2, the superlattice structure 300 may include at least one unit superlattice structure 310. For example, the superlattice structure 300 may include two or more unit superlattice structures 310. At least one unit superlattice structure 310 may be stacked on the first semiconductor layer 131 in the third direction (Z direction). Accordingly, the superlattice structure 300 may have a structure in which the unit superlattice structure 310 is repeatedly stacked in the third direction (Z direction). In FIG. 2, three unit superlattice structures 310 are shown as being stacked in the third direction (Z direction), but the number of unit superlattice structures 310 is not limited thereto.

The unit superlattice structure 310 may include a plurality of superlattice layers 301, 302 having different energy band gaps. For example, the unit superlattice structure 310 may include the first superlattice layer 301 and the second superlattice layer 302 positioned on the first superlattice layer 301. Accordingly, the superlattice structure 300 may have a structure in which a plurality of superlattice layers 301, 302 are alternately stacked. For example, the first superlattice layer 301 and the second superlattice layer 302 may be alternately stacked on the first semiconductor layer 131. The superlattice structure 300 may have a structure in which unit layers are repeated at least once. Here, the unit layer may be the first superlattice layer 301, the second superlattice layer 302, or a pair layer thereof, but is not limited thereto. As an example, a first superlattice layer 301 may be positioned directly on the upper surface of the first semiconductor layer 131, and a second superlattice layer 302 may be positioned on the first superlattice layer 301, but is not limited thereto. As another example, the second superlattice layer 302 may be positioned directly on the upper surface of the first semiconductor layer 131. The first superlattice layer 301 may be positioned at a lower portion of the unit superlattice structure 310. The first superlattice layer 301 may be positioned on the upper surface of the first semiconductor layer 131. The second superlattice layer 302 may be positioned between the first superlattice layers 301 spaced apart in the third direction (Z direction). The thicknesses of the first superlattice layer 301 and the second superlattice layer 302 in the third direction (Z direction) may be 10 nm or less, but are not limited thereto.

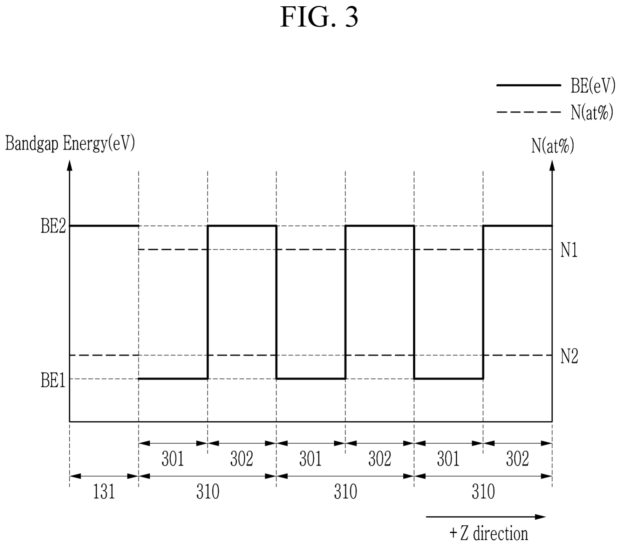

The superlattice structure 300 may be an epitaxy layer formed by epitaxial growth from the first semiconductor layer 131. The superlattice structure 300 may include the same semiconductor material as the first semiconductor layer 131 and the second semiconductor layer 132, which will be described later. For example, the superlattice structure 300 may be SiₐC₁₋ₐ (0<a<1). In this case, the superlattice structure 300 may be configured with a plurality of layers having different Si contents. Specifically, the first superlattice layer 301 and the second superlattice layer 302 may include a first element and a second element. Here, the first element may be Si, and the second element may be C, but is not limited thereto. In this case, the semiconductor material forming the first superlattice layer 301 may have the first energy band gap BE1 (see FIG. 3), and the semiconductor material forming the second superlattice layer 302 may have the second energy band gap BE2 (see FIG. 3). Description thereof will be given below with reference to FIG. 3.

In another example, the superlattice structure 300 may be Si_{b}Ge_{c}C_{1-b-c}/SiₐC₁₋ₐ (0<a<1, 0≤b≤1, 0<c≤1, b+c≤1). The superlattice structure 300 may have a structure in which layers including Si_{b}Ge_{c}C_{1-b-c} and layers including SiₐC₁₋ₐ are repeatedly laminated. As another example, the superlattice structure 300 may be AlₓIn_{y}Ga_{1-x-y}N/GaN (0≤x≤1, 0≤y≤1, x+y≤1). The superlattice structure 300 may include InGaN/GaN, AlGaN/GaN, InAlGaN/GaN, or combinations thereof. A detailed description thereof will be given below with reference to FIG. 3.

The superlattice structure 300 may have a first conductivity type. The superlattice structure 300 may be doped with a first conductivity type impurity. For example, the first conductivity type impurity may be an n-type impurity. The superlattice structure 300 may be doped as n-type.

The second semiconductor layer 132 may be positioned on the superlattice structure 300. The second semiconductor layer 132 may be positioned on the upper surface of the superlattice structure 300. The second semiconductor layer 132 may be in contact with the upper surface of the superlattice structure 300, but is not limited thereto. For example, the second semiconductor layer 132 may contact the upper surface of the first superlattice layer 301. In another example, the second semiconductor layer 132 may contact an upper surface of the second superlattice layer 302. The second semiconductor layer 132 may overlap the superlattice structure 300 and the first semiconductor layer 131 in a third direction (Z direction). The second semiconductor layer 132 may completely cover the upper surface of the superlattice structure 300. Accordingly, the superlattice structure 300 may be positioned between the first semiconductor layer 131 and the second semiconductor layer 132. The second semiconductor layer 132 may be an epitaxy layer formed using an epitaxial growth from the superlattice structure 300.

The second semiconductor layer 132 may include the same material as the first semiconductor layer 131. For example, the second semiconductor layer 132 may include SiC. The second semiconductor layer 132 may include 4H SiC. The second semiconductor layer 132 may have a first conductivity type. The second semiconductor layer 132 may be doped with a first conductivity type impurity. For example, the first conductivity type impurity may be an n-type impurity. The second semiconductor layer 132 may be doped with a low concentration as n-type. The doping concentration of the second semiconductor layer 132 may be substantially the same as the doping concentration of the first semiconductor layer 131, but is not limited thereto. Here, having substantially the same doping concentration may mean that the average doping concentration of the first semiconductor layer 131 and the average doping concentration of the second semiconductor layer 132 are substantially the same, or that the maximum doping concentration of the first semiconductor layer 131 and the maximum doping concentration of the second semiconductor layer 132 are substantially the same.

The doped well region 133 may be positioned in the second semiconductor layer 132. The doped well region 133 may be positioned on an upper portion of the second semiconductor layer 132. The doped well region 133 may be positioned spaced apart from the superlattice structure 300 in the third direction (Z direction). The doped well region 133 may be positioned spaced apart from the first semiconductor layer 131 in the third direction (Z direction). At least a portion of the upper surface of the doped well region 133 may overlap, in the third direction (Z direction), with the gate electrode 150 to be described later and the gate insulating layer 151 to be described later, but is not limited thereto. Here, the third direction (Z direction) may refer to a thickness direction of the substrate 110 and/or a vertical direction perpendicular to the first surface 110a of the substrate 110. The doped well region 133 may extend from the upper surface of the second semiconductor layer 132 toward the lower surface of the second semiconductor layer 132. That is, the doped well region 133 may extend in the third direction (Z direction) from an upper surface of the second semiconductor layer 132. The doped well region 133 may be formed by an ion implantation method in at least a portion of a region of the second semiconductor layer 132, but is not limited thereto.

The doped well region 133 may include SiC. For example, the doped well region 133 may include 4H SiC. The doped well region 133 may have a second conductivity type. The doped well region 133 may be doped with a second conductivity type impurity. For example, the second conductivity type impurity may be a p-type impurity. The doped well region 133 may be doped as a p-type. The doped well region 133 may be doped with a low concentration as a p-type. The doping concentration of the doped well region 133 may be about 1*10¹⁷cm⁻³ or more and about 1*10¹⁹cm⁻³ or less. The material, doping type, and doping concentration of the doped well region 133 are not limited thereto and may be variously changed.

In one implementation, the doped well region 133 may be used as a channel of a transistor forming a semiconductor device. For example, a portion of the doped well region 133 adjacent to the gate electrode 150, which will be described later, may function as a channel of the transistor. At least a portion of the doped well region 133 may have a current path formed from the second electrode 175 toward the first electrode 173.

A semiconductor device according to an implementation may further include a pillar layer 200 positioned within the first semiconductor layer 131.

The pillar layer 200 may be positioned between the substrate 110 and the doped well region 133. The pillar layer 200 may penetrate the unit superlattice structure 310. For example, the pillar layer 200 may penetrate the superlattice structure 300. A side surface of the pillar layer 200 may be in contact with the unit superlattice structure 310. The superlattice structure 300 may be separated from each other in a first direction (X direction) by the pillar layer 200. A lower surface of the pillar layer 200 may be positioned at a lower level than a lower surface of the superlattice structure 300. The distance between the lower surface of the pillar layer 200 and the first surface 110a of the substrate 110 may be less than or equal to the distance between the lower surface of the superlattice structure 300 and the first surface 110a of the substrate 110, but is not limited thereto. The pillar layer 200 may be overlapped with the second semiconductor layer 132, the superlattice structure 300, and the first semiconductor layer 131 in the first direction (X direction). A side surface of the pillar layer 200 may contact the second semiconductor layer 132, the superlattice structure 300, and the first semiconductor layer 131, but is not limited thereto. The pillar layer 200 may overlap the doped well region 133 in the third direction (Z direction), and may be non-overlapping with the gate electrode 150, which will be described later, in the third direction (Z direction).

The pillar layer 200 may extend in the third direction (Z direction). For example, the pillar layer 200 may extend in the third direction (Z direction) toward the substrate 110 from the lower surface of the doped well region 133 through the superlattice structure 300. The pillar layer 200 may be positioned spaced apart from the substrate 110 in the third direction (Z direction). A lower surface of the pillar layer 200 may be positioned at a higher level than the first surface 110a of the substrate 110. A first semiconductor layer 131 may be positioned between the pillar layer 200 and the substrate 110. At least a portion of the pillar layer 200 may be surrounded by the first semiconductor layer 131. For example, a side surface and a lower surface of the pillar layer 200 may be surrounded by the first semiconductor layer 131.

A semiconductor device according to one implementation may include a plurality of pillar layers 200 spaced apart and arranged in a first direction (X direction) within the first semiconductor layer 131, and penetrating the superlattice structure 300. A plurality of pillar layers 200 may be positioned directly below the doped well region 133. A superlattice structure 300 and a first semiconductor layer 131 may be positioned between the plurality of pillar layers 200. The lengths of each of the plurality of pillar layers 200 in the third direction (Z direction) may be substantially identical, but are not limited thereto.

The pillar layer 200 may include a semiconductor material. The pillar layer 200 may include the same material as the first semiconductor layer 131, the second semiconductor layer 132, and the doped well region 133. For example, the pillar layer 200 may include SiC. The pillar layer 200 may be an epitaxy layer formed from the first semiconductor layer 131, the superlattice structure 300, and the second semiconductor layer 132 by using epitaxial growth. The pillar layer 200 may have a second conductivity type. The pillar layer 200 may be doped with a second conductivity type impurity. Here, the second conductive type may be a p-type. The material of the pillar layer 200 is not limited thereto, and as another example, the first semiconductor layer 131, the doped well region 133, and the pillar layer 200 may include GaN.

The gate electrode 150 may be positioned adjacent to the doped well region 133.

In one implementation, the gate electrode 150 may be positioned on the doped well region 133. The gate electrode 150 may be spaced apart from the doped well region 133 in a third direction (Z direction). The gate electrode 150 may be positioned on the second semiconductor layer 132. The gate electrode 150 may be spaced apart from the second semiconductor layer 132. For example, the gate electrode 150 may be spaced apart from the second semiconductor layer 132 in the third direction (Z direction) by the gate insulating layer 151. A semiconductor device according to an implementation may have a gate structure of a planar type. That is, in the semiconductor device according to the implementation, the gate electrode 150 has a plate shape having flat upper and lower surfaces, and the lower surface of the gate electrode 150 may be positioned at a higher level than the uppermost surface of the second semiconductor layer 132.

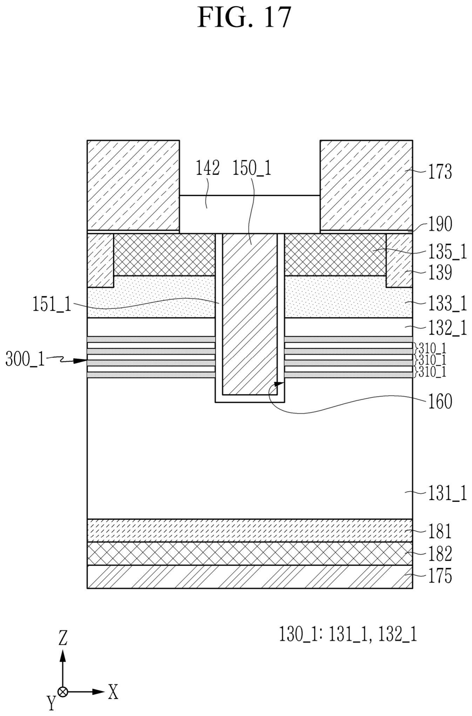

However, example implementations are not limited thereto, and the semiconductor device according to the implementation may have a gate structure in the form of a trench. For example, in the semiconductor device according to an implementation, a trench having a predetermined depth is formed in the second semiconductor layer 132, and a gate electrode 150 may be positioned spaced apart from the second semiconductor layer 132 in the third direction (Z direction) inside the trench. A detailed description thereof will be given below in reference to FIGS. 17 to 19.

The gate electrode 150 may include a conductive material. For example, the gate electrode 150 may include polysilicon doped with impurities. As another example, the gate electrode 150 may include a metal, a metal alloy, a conductive metal nitride, a metal silicide, a doped semiconductor material, a conductive metal oxide, a conductive metal oxynitride, or a combination thereof. The gate electrode 150 may be formed of a single layer or multiple layers.

The gate insulating layer 151 may be positioned between the second semiconductor layer 132 and the gate electrode 150, and between the doped well region 133 and the gate electrode 150. That is, the gate insulating layer 151 may be positioned under the gate electrode 150, and may cover a lower surface of the gate electrode 150. The thickness of the gate insulating layer 151 may be almost constant. In one implementation, the gate insulating layer 151 may overlap the doped well region 133 in the third direction (Z direction). A lower surface of the gate insulating layer 151 may contact the doped well region 133, but is not limited thereto.

The gate insulating layer 151 may include an insulating material. For example, the gate insulating layer 151 may include SiO₂. However, example implementations are not limited thereto, and the material of the gate insulating layer 151 may be variously changed. As another example, the gate insulating layer 151 may include SiN, SiON, SiC, SiCN, or a combination thereof. The gate insulating layer 151 may be formed of a single layer or a plurality of layers.

The first doped layer 135 may be positioned in the doped well region 133. The first doped layer 135 may be positioned on an upper portion of the second semiconductor layer 132, and may have an upper surface contacting a lower surface of a silicide layer 190 connected to the first electrode 173, which will be described later. In one implementation, at least a partial region of an upper surface of the first doped layer 135 may be in contact with a lower surface of the silicide layer 190, which will be described later, but is not limited thereto. As another example, at least a partial region of an upper surface of the first doped layer 135 may be in contact with a lower surface of the first electrode 173. The first doped layer 135 may be embedded in the doped well region 133.

In one implementation, the first doped layer 135 may extend in the third direction (Z direction) from an upper surface of the second semiconductor layer 132. In this case, the thickness of the first doped layer 135 in the third direction (Z direction) may be less than the thickness of the doped well region 133 in the third direction (Z direction). The first doped layer 135 may be formed on at least a portion of the doped well region 133 by an ion implantation method, but is not limited thereto.

The first doped layer 135 may include SiC. For example, the first doped layer 135 may include 4H SiC. The first doped layer 135 may be doped with the first conductivity type impurity. The first doped layer 135 may be doped as an n-type. The first doped layer 135 may form ohmic contact with the first electrode 173. To this end, the first doped layer 135 may be doped with a high concentration as an n-type. In the implementation, the doping concentration of the first doped layer 135 may be higher than the doping concentration of the second semiconductor layer 132. The doping concentration of the first doped layer 135 may be about 1*10¹⁸cm⁻³ or more and about 5*10²⁰cm⁻³ or less. The material, doping type, doping concentration, and the like of the first doped layer 135 are not limited thereto and may be variously modified.

A semiconductor device according to one implementation may further include a second doped layer positioned within the doped well region 133. The second doped layer may be positioned on a side surface of the first doped layer 135. The second doped layer may be positioned between the first electrode 173 and the doped well region 133. The second doped layer may include SiC. For example, the second doped layer may include 4H SiC. The second doped layer may be doped with the second conductivity type impurity. The second doped layer may be doped to be p-type.

The semiconductor device according to one implementation may further include an interlayer insulating layer 140 positioned on the gate electrode 150.

The interlayer insulating layer 140 may be positioned on the second semiconductor layer 132. The interlayer insulating layer 140 may be positioned on the gate electrode 150. Specifically, the interlayer insulating layer 140 may cover the upper surface and a side surface of the gate electrode 150. The interlayer insulating layer 140 may cover the side surface of the gate insulating layer 151. The interlayer insulating layer 140 may be positioned on at least a portion of the doped well region 133 and/or on at least a portion of the first doped layer 135. The gate electrode 150 may be insulated from the first electrode 173 by the interlayer insulating layer 140.

The interlayer insulating layer 140 may include an insulating material. The interlayer insulating layer 140 may include the same insulating material as the gate insulating layer 151. For example, the interlayer insulating layer 140 may include SiO₂. However, example implementations are not limited thereto, and the interlayer insulating layer 140 may include various types of insulating materials for electrically insulating the gate electrode 150 from the first electrode 173. For example, the interlayer insulating layer 140 may include SiOP, SiN, SiON, or a combination thereof. The interlayer insulating layer 140 may be formed as a single layer or a multilayer. When the interlayer insulating layer 140 is formed of the same material as the gate insulating layer 151, the boundary between the interlayer insulating layer 140 and the gate insulating layer 151 at the portion where the interlayer insulating layer 140 is contacting the gate insulating layer 151 may not be clearly distinguished.

The first electrode 173 may be positioned on the doped well region 133. The first electrode 173 may be positioned on the first doped layer 135. The first electrode 173 may be electrically connected to the doped well region 133 through the first doped layer 135. The first electrode 173 may function as a source electrode of a transistor forming a semiconductor device. For example, when the semiconductor device has a superjunction structure, the first electrode 173 may function as a source electrode of the superjunction transistor. However, example implementations are not limited thereto, and as another example, the first electrode 173 may also function as the emitter electrode of an insulated gate bipolar transistor (IGBT). Description thereof will be given below in the implementations of FIGS. 17 to 19.

The first electrode 173 of the semiconductor device according to an implementation may include a contact portion 173C positioned between a plurality of gate electrodes 150 that are spaced apart and positioned in the first direction (X direction).

The contact portion 173C may be positioned between the plurality of gate electrodes 150 spaced apart in the first direction (X direction). The contact portion 173C may refer to a portion of the first electrode 173 positioned between a plurality of gate electrodes 150 that are spaced apart and positioned in the first direction (X direction). The contact portion 173C may extend in a direction parallel to the gate electrode 150. The contact portion 173C may be positioned on a side surface of the gate electrode 150. An interlayer insulating layer 140 may be positioned between the contact portion 173C and the gate electrode 150. The contact portion 173C may be spaced apart from the gate electrode 150 by the interlayer insulating layer 140. The contact portion 173C may be in contact with a side surface of the interlayer insulating layer 140.

The contact portion 173C may overlap the doped well region 133 in the third direction (Z direction). For example, the contact portion 173C may overlap a portion of the doped well region 133 in the third direction (Z direction). In some implementations, the contact portion 173C may overlap the pillar layer 200 in the third direction (Z direction). At least a portion of the contact portion 173C may overlap the first doped layer 135 in the third direction (Z direction).

The first electrode 173 may include a conductive material. For example, the first electrode 173 may include a metal, metal alloy, conductive metal nitride, metal silicide, doped semiconductor material, conductive metal oxide, or conductive metal oxynitride. For example, the first electrode 173 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combinations thereof, but is not limited thereto. The first electrode 173 may be formed as a single layer or a multilayer.

A semiconductor device according to one implementation may further include a silicide layer 190 positioned between the first electrode 173 and the first doped layer 135, and between the first electrode 173 and the doped well region 133.

The silicide layer 190 may be positioned conformally along the interface between the first electrode 173 and the first doped layer 135, and between the first electrode 173 and the doped well region 133. The silicide layer 190 may be positioned between the contact portion 173C of the first electrode 173 and the doped well region 133. A lower surface of the silicide layer 190 may contact the first doped layer 135 and the doped well region 133. In one implementation, a lower surface of the silicide layer 190 may be in contact with the doped well region 133. An upper surface of the silicide layer 190 may be in contact with the first electrode 173.

The silicide layer 190 may include a metal silicide material. For example, the silicide layer 190 may include tungsten silicide (WSi), titanium silicide (TiSi), cobalt silicide (CoSi), nickel silicide (NiSi), or a combination thereof.

The second electrode 175 may be positioned on the second surface 110b of the substrate 110, that is, on the lower surface. The upper surface of the second electrode 175 may contact the lower surface of the substrate 110. The second electrode 175 may be in ohmic contact with the substrate 110. An area of the substrate 110 in contact with the second electrode 175 may be relatively heavily doped compared to other areas. However, example implementations are not limited thereto, and an additional predetermined layer may be further positioned between the second electrode 175 and the substrate 110. For example, a silicide layer may be positioned between the second electrode 175 and the substrate 110. The silicide layer may include a metal silicide material. The second electrode 175 and the substrate 110 may be electrically smoothly connected by a metal silicide layer.

The second electrode 175 may function as a drain electrode of a transistor forming a semiconductor device. For example, when the semiconductor device has a super junction structure, the second electrode 175 may function as a drain electrode of the super junction transistor. However, example implementations are not limited thereto, and as another example, the second electrode 175 may function as a collector electrode of an insulated gate bipolar transistor (IGBT). A description regarding this will be provided below in the implementations of FIGS. 17 to 19.

The second electrode 175 may include a conductive material. For example, the second electrode 175 may include a metal, a metal alloy, a conductive metal nitride, a metal silicide, a doped semiconductor material, a conductive metal oxide, or a conductive metal oxynitride. The second electrode 175 may be formed of the same material as the first electrode 173, or may be formed of a different material. The second electrode 175 may be formed as a single layer or a multilayer.

Hereinafter, a detailed description will be given of the superlattice structure of a semiconductor device according to an implementation, with further reference to FIG. 3.

FIG. 3 is a graph showing the content of the material forming the first semiconductor layer and the superlattice structure of the semiconductor device according to an implementation. In FIG. 3, the energy band gap of the first semiconductor layer 131 and the superlattice structure 300 and the content of the first element according to the positive vertical direction (hereinafter, '+Z direction') are shown. Herein, 'content' may mean atomic percent (at%).

The first semiconductor layer 131, the superlattice structure 300, and second semiconductor layer 132 of the semiconductor device according to one implementation may include a first element, which is a semiconductor element, and a second element different from the first element. Here, the first element may be Si, and the second element may be C, but it is not limited thereto. As an example, the first semiconductor layer 131, the first superlattice layer 301, the second superlattice layer 302, and the second semiconductor layer 132 may be SiₐC₁₋ₐ (0<a<1).

In one implementation, the first semiconductor layer 131, the superlattice structure 300, and the second semiconductor layer 132 may include a material having a predetermined energy band gap. In this case, the energy band gap may be determined according to the content (at%) ratio of a first element and a second element of the semiconductor material forming the first semiconductor layer 131, the superlattice structure 300, and the second semiconductor layer 132. Specifically, as the content (at%) of the first element, which is a semiconductor element, increases, the energy band gap tends to become smaller. That is, as the content (at%) of the second element increases, the energy band gap tends to become larger. As an example, the first superlattice layer 301 of the semiconductor device according to an implementation may include a material having a first energy band gap BE1, and the second superlattice layer 302 may include a material having a second energy band gap BE2.

Referring further to FIG. 3, the superlattice structure 300 may include portions having different energy band gaps. Each unit superlattice structure 310 may include a portion having a different energy band gap. For example, the first energy band gap BE1 of the first superlattice layer 301 of the unit superlattice structure 310 may be less than the second energy band gap BE2 of the second superlattice layer 302 positioned on the first superlattice layer 301. The second energy band gap BE2 of the second superlattice layer 302 may be substantially the same as the energy band gap of the first semiconductor layer 131. In some implementations, the second energy band gap BE2 of the second superlattice layer 302 may be substantially identical to the energy band gap of the second semiconductor layer 132. The first energy band gap BE1 and the second energy band gap BE2 may have a substantially constant magnitude, however, example implementations are not limited thereto. The conductivity of the first superlattice layer 301 may be greater than the conductivity of the second superlattice layer 302.

According to the implementation, the content N1 of the first element of the first superlattice layer 301 may be different from the content N2 of the first element of the second superlattice layer 302. For example, as the content of the first element, which is a semiconductor element, increases, the energy band gap tends to decrease. Therefore, the content N1 of the first element in the first superlattice layer 301 may be greater than the content N2 of the first element in the second superlattice layer 302. The content of the second element in the first superlattice layer 301 may be less than the content of the second element in the second superlattice layer 302. In some implementations, the content N2 of the first element of the second superlattice layer 302 may be substantially the same as the content of the first element of the first semiconductor layer 131; however, it is not limited thereto. In another example, the content N2 of the first element of the second superlattice layer 302 may be less than the content of the first element of the first semiconductor layer 131. Here, the first element may be Si and the second element may be C, but is not limited thereto.

The type and content of material of the first superlattice layer 301 and the second superlattice layer 302 may be variously changed within a range in which the first energy band gap BE1 is less than the second energy band gap BE2. In an example implementation, the first superlattice layer 301 may further include a third element. Here, the third element may be Ge, but is not limited thereto. That is, the first superlattice layer 301 may be Si_{b}Ge_{c}C_{1-b-c} (0≤b≤1, 0<c≤1, b+c≤1), and the first semiconductor layer 131, the second superlattice layer 302, and the second semiconductor layer 132 may be SiₐC₁₋ₐ (0<a<1). As the content of the third element increases, the energy band gap tends to decrease. In this case, the content of the second element in the first superlattice layer 301 may be less than or equal to the content of the second element in the second superlattice layer 302. Even when the content of the second element of the first superlattice layer 301 is the same as the content of the second element of the second superlattice layer 302, since the first superlattice layer 301 further includes a third element, the first energy band gap BE1 may become less than the second energy band gap BE2. In this case, the content of the third element in the first superlattice layer 301 may be about 10at% to about 50at%. Within this range, it is possible to prevent a decrease in the breakdown voltage of the semiconductor device due to a reduction in the energy band gap of the entire superlattice structure 300, while simultaneously preventing an increase in the operating voltage of the semiconductor device.

As another example, the first superlattice layer 301 and the second superlattice layer 302 may each be Si_{b}Ge_{c}C_{1-b-c} (0≤b≤1, 0<c≤1, b+c≤1). In this case, the content of the third element in the first superlattice layer 301 may be greater than the content of the third element in the second superlattice layer 302. In some implementations, the content of the second element in the first superlattice layer 301 may be less than or equal to the content of the second element in the second superlattice layer 302. Specifically, even when the content of the second element in the first superlattice layer 301 and the content of the second element in the second superlattice layer 302 are substantially the same, when the content of the third element in the first superlattice layer 301 is greater than the content of the third element in the second superlattice layer 302, the first energy band gap BE1 may become less than the second energy band gap BE2. In some implementations, even when the content N1 of the first element of the first superlattice layer 301 and the content N2 of the first element of the second superlattice layer 302 are substantially the same, if the content of the third element of the first superlattice layer 301 is greater than the content of the third element of the second superlattice layer 302, the first energy band gap BE1 may become less than the second energy band gap BE2. In this case, the content of the third element in the first superlattice layer 301 may be about 10 at% to about 50 at%, and the content of the third element in the second superlattice layer 302 may be about 30 at% or less. In this range, it is possible to prevent a decrease in the breakdown voltage of the semiconductor device due to the reduction in the energy band gap of the entire superlattice structure 300, and at the same time, it may be possible to prevent an increase in the operating voltage of the semiconductor device.

As another example, in an example implementation, the first element may include Ga, the second element may include N, and the third element may also include In. The first superlattice layer 301 may be In_{y}Ga_{1-y}N (0≤y≤1), and the second superlattice layer 302 may be GaN. In some implementations, the first semiconductor layer 131 and the second semiconductor layer 132 may be formed of GaN. In this case as well, the energy band gap tends to decrease as the content of the third element increases. Therefore, as the first superlattice layer 301 includes In, the first energy band gap BE1 may become less than the second energy band gap BE2.

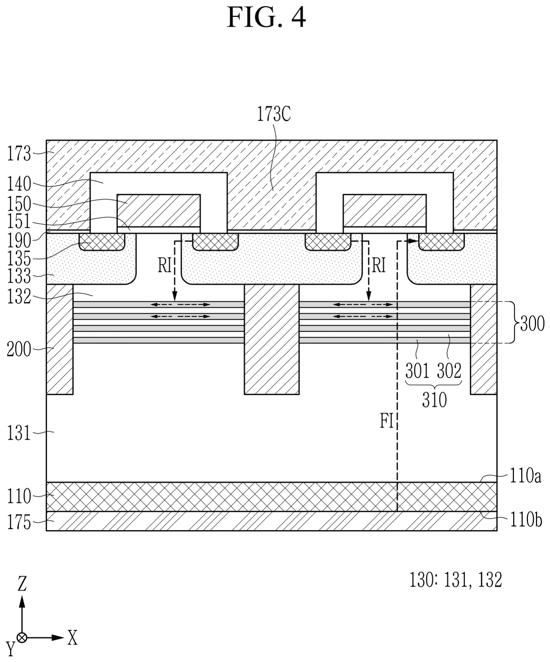

Hereinafter, a semiconductor device according to an implementation will be described with further reference to FIG. 4.

FIG. 4 is a cross-sectional view illustrating a reverse current of a semiconductor device according to an implementation.

Referring further to FIG. 4, the semiconductor device according to an implementation may be a superjunction transistor. For example, the first electrode 173 may constitute a source electrode of the superjunction transistor, the second electrode 175 may constitute a drain electrode of the superjunction transistor, the gate electrode 150 may constitute a gate electrode of the superjunction transistor, and at least a portion of the doped well region 133 may constitute a channel of the superjunction transistor.

When a turn-on signal is applied to the gate electrode 150, in the semiconductor device according to one implementation, a flow of driving current FI may be generated from the second electrode 175 toward the first electrode 173. The driving current FI may flow in the +Z direction. In a semiconductor device according to one implementation, even when a turn-on signal is not applied to the gate electrode 150, a flow of reverse current RI from the first electrode 173 toward the second electrode 175 may occur. The reverse current RI refers to a leakage current flowing in the direction opposite to the driving current FI. That is, the reverse current RI may flow from the first electrode 173 to the second electrode 175 in the negative vertical direction (hereinafter, '-Z direction'). Reverse current RI may be generated as carriers move from the second electrode 175 through the first conductivity type substrate 110, the first semiconductor layer 131, the superlattice structure 300, the second semiconductor layer 132, the doped well region 133, and the first doped layer 135 to the first electrode 173. There may occur a problem in which the breakdown voltage characteristic of a semiconductor device is degraded by reverse current RI.

The superlattice structure 300 of the semiconductor device according to one implementation may include at least one unit superlattice structure 310 positioned between the first semiconductor layer 131 and the second semiconductor layer 132. The unit superlattice structure 310 may include a first superlattice layer 301 having a first energy band gap BE1 less than the second energy band gap BE2 of the second superlattice layer 302. Accordingly, an energy barrier may exist at the interface between the first superlattice layer 301 and the second superlattice layer 302. Therefore, when a carrier moves in the +Z direction within the superlattice structure 300, the movement of the carrier in the +Z direction may be suppressed by the energy barrier between the first superlattice layer 301 and the second superlattice layer 302, and the carrier may remain in the first superlattice layer 301 and/or the second superlattice layer 302 or diffuse in the horizontal direction (for example, the first direction (X direction) and/or the second direction (Y direction)). That is, the occurrence of reverse current RI may be reduced by the effect of suppressing carrier movement in the +Z direction. Therefore, the leakage current of the semiconductor device according to one implementation may be reduced, and the breakdown voltage characteristics may be improved. Accordingly, the reliability of the semiconductor device according to an implementation may be improved.

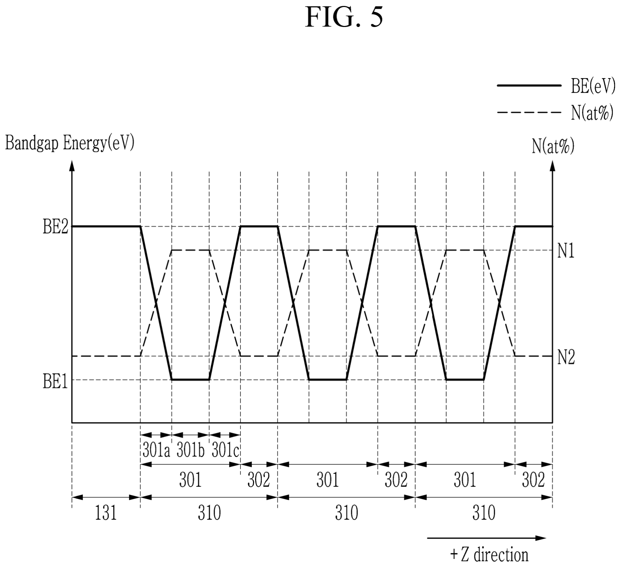

Hereinafter, a description will be given of the superlattice structure of a semiconductor device according to several implementations with reference to FIGS. 5 to 7.

FIGS. 5 to 7 are graphs showing the content of materials forming the first semiconductor layer and the superlattice structure of a semiconductor device according to some implementations.

FIGS. 5 to 7 illustrate various modifications of the semiconductor device according to an implementation shown in FIGS. 1 to 4. FIGS. 5 to 7 illustrate implementations wherein substantial portions are identical to those of the implementations illustrated in FIGS. 1 to 4, and thus, a description thereof will be omitted and differences will be mainly described. Also, the same reference numerals are used for components identical to those of the previous implementations.

Referring to FIG. 5, the first superlattice layer 301 of the semiconductor device according to some implementations may include a portion having different energy band gaps as it becomes farther from the upper surface of the first semiconductor layer 131. For example, the first superlattice layer 301 may include a first portion 301a in which the energy band gap decreases as it becomes more distant from the upper surface of the first semiconductor layer 131, a second portion 301b in which the energy band gap is constant, and a third portion 301c in which the energy band gap increases. In the unit superlattice structure 310, the first portion 301a to the third portion 301c may be sequentially stacked. The second superlattice layer 302 may be positioned on the third portion 301c. Since the unit superlattice structure 310 is repeatedly stacked in the third direction (Z direction), a first portion 301a may be positioned on the second superlattice layer 302.

The energy band gap of the first portion 301a may decrease as the distance from the upper surface of the first semiconductor layer 131 increases. The energy band gap of the first portion 301a may have a maximum value at a point adjacent to the first semiconductor layer 131 or the second superlattice layer 302, and may have a minimum value at a point adjacent to the second portion 301b. The energy band gap of the second portion 301b may be constant, but is not limited thereto. The energy band gap of the third portion 301c may increase as it becomes farther from the upper surface of the first semiconductor layer 131. The energy band gap of the third portion 301c has a maximum value at a point adjacent to the second superlattice layer 302, and may have a minimum value at a point adjacent to the second portion 301b.

In some implementations, the energy band gap of the superlattice structure 300 may have a continuous value. For example, the change in the energy band gap at the interface between the first portion 301a and the second portion 301b, the interface between the second portion 301b and the third portion 301c, the interface between the third portion 301c and the second superlattice layer 302, and the interface between the second superlattice layer 302 and the first portion 301a may be continuous.

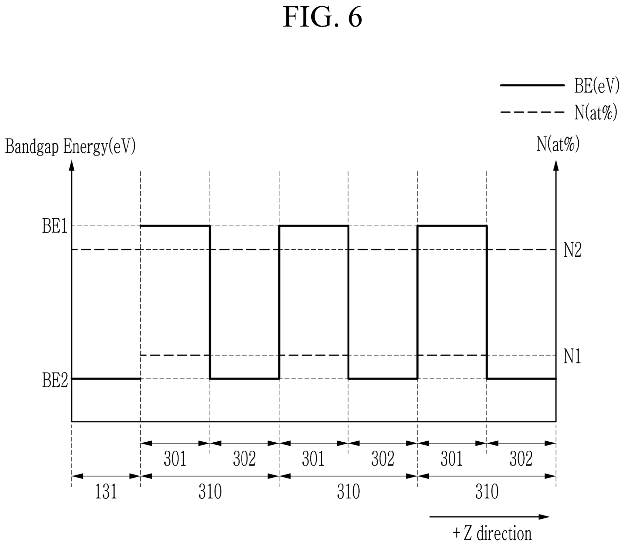

Referring to FIG. 6, the first energy band gap BE1 of the first superlattice layer 301 of the unit superlattice structure 310 of a semiconductor device according to some implementations may be greater than the second energy band gap BE2 of the second superlattice layer 302 positioned on the first superlattice layer 301. The second energy band gap BE2 of the second superlattice layer 302 may be substantially the same as the energy band gap of the first semiconductor layer 131. In some implementations, the second energy band gap BE2 of the second superlattice layer 302 may be substantially the same as the energy band gap of the second semiconductor layer 132. The first energy band gap BE1 and the second energy band gap BE2 may have a substantially constant magnitude; however, example implementations are not limited thereto. The conductivity of the first superlattice layer 301 may be less than the conductivity of the second superlattice layer 302.

According to the implementation, the content N1 of the first element of the first superlattice layer 301 may be different from the content N2 of the first element of the second superlattice layer 302. For example, as the content of a first element, which is a semiconductor element, increases, there is a tendency for the energy band gap to decrease. Thus, the content N1 of the first element in the first superlattice layer 301 may be less than the content N2 of the first element in the second superlattice layer 302. The content of the second element of the first superlattice layer 301 may be greater than the content of the second element of the second superlattice layer 302. In some implementations, the content N2 of the first element of the second superlattice layer 302 may be substantially identical to the content of the first element of the first semiconductor layer 131, but is not limited thereto. In another example, the content N2 of the first element of the second superlattice layer 302 may be greater than the content of the first element of the first semiconductor layer 131. Here, the first element may be Si, and the second element may be C, but is not limited thereto.

The type and content of the materials of the first superlattice layer 301 and the second superlattice layer 302 may be variously changed within a range in which the first energy band gap BE1 is less than the second energy band gap BE2. In an example implementation, the first superlattice layer 301 may further include a third element. Here, the first element may include Ga, the second element may include N, and the third element may include Al. For example, the first superlattice layer 301 may be Al_{z}Ga_{1-z}N (0≤Z≤1), and the second superlattice layer 302 may be GaN. In some implementations, the first semiconductor layer 131 and the second semiconductor layer 132 may be formed of GaN. In this case, as the content of the third element increases, the energy band gap tends to increase. Therefore, as the first superlattice layer 301 includes AI, the first energy band gap BE1 may become greater than the second energy band gap BE2.

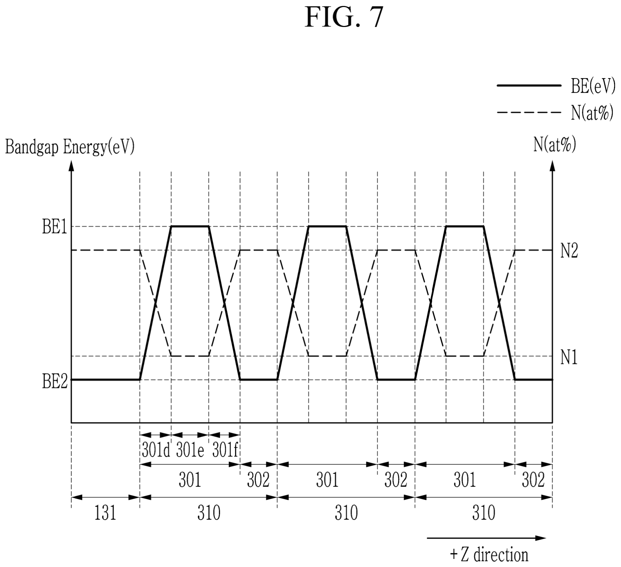

Referring to FIG. 7, the first superlattice layer 301 of a semiconductor device according to some implementations may include a portion having a different energy band gap as it becomes distant from an upper surface of the first semiconductor layer 131. For example, the first superlattice layer 301 may include a fourth portion 301d in which the energy band gap increases as it gets farther from the upper surface of the first semiconductor layer 131, a fifth portion 301e in which the energy band gap is constant, and a sixth portion 301f in which the energy band gap increases. In the unit superlattice structure 310, the fourth portion 301d to the sixth portion 301f may be sequentially stacked. The second superlattice layer 302 may be positioned on the sixth portion 301f. Since the unit superlattice structure 310 is repetitively stacked in the third direction (Z direction), a fourth portion 301d may be positioned on the second superlattice layer 302.

The energy band gap of the fourth portion 301d may increase as it becomes farther away from the upper surface of the first semiconductor layer 131. The energy band gap of the fourth portion 301d has a minimum value at a point adjacent to the first semiconductor layer 131 or the second superlattice layer 302, and may have a maximum value at a point adjacent to the fifth portion 301e. The energy band gap of the fifth portion 301e may be constant, but is not limited thereto. The energy band gap of the sixth portion 301f may decrease as it becomes farther from the upper surface of the first semiconductor layer 131. The energy band gap of the sixth portion 301f has a minimum value at a point adjacent to the second superlattice layer 302, and may have a maximum value at a point adjacent to the fifth portion 301e.

In some implementations, the energy band gap of the superlattice structure 300 may have continuous values. For example, the change in energy band gap at the interface between the fourth portion 301d and the fifth portion 301e, the interface between the fifth portion 301e and the sixth portion 301f, the interface between the sixth portion 301f and the second superlattice layer 302, and the interface between the second superlattice layer 302 and the fourth portion 301d may be continuous.

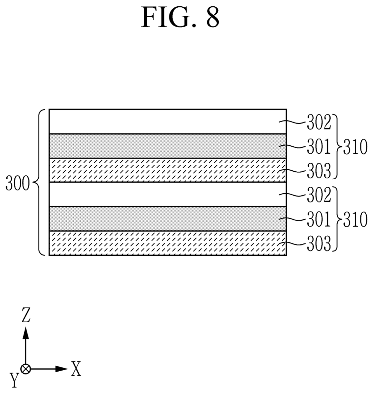

Hereinafter, a description will be given of the superlattice structure of a semiconductor device according to several implementations with reference to FIGS. 8 to 11.

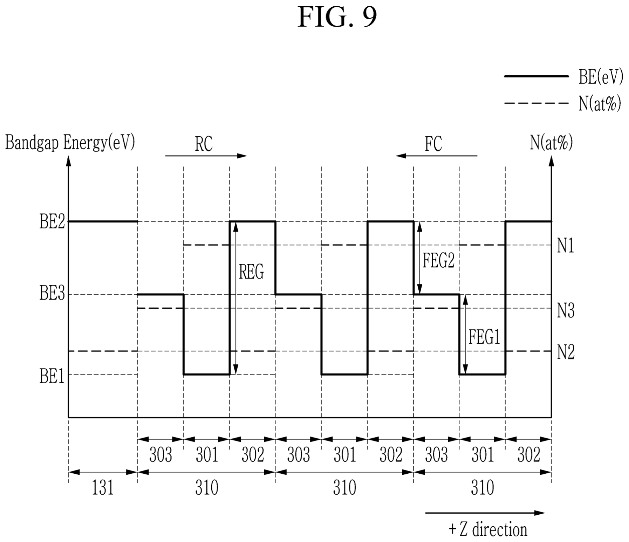

FIG. 8 is a cross-sectional view showing a superlattice structure of a semiconductor device according to some implementations. FIGS. 9 to 11 are graphs illustrating the content of substances forming the first semiconductor layer and the superlattice structure in the semiconductor device according to some implementations.

FIGS. 8 to 11 illustrate various modifications of the semiconductor device according to one implementation shown in FIGS. 1 to 4. The implementations illustrated in FIGS. 8 to 11 correspond substantially to the same parts as those of the implementations illustrated in FIGS. 1 to 4, and therefore, detailed description thereof will be omitted, focusing mainly on differences. In addition, the same reference numerals are used for components identical to those of the previous implementation.

Referring to FIG. 8, the unit superlattice structure 310 of a semiconductor device according to some implementations may further include a third superlattice layer 303 positioned on the lower surface of the first superlattice layer 301.

In the unit superlattice structure 310, the third superlattice layer 303 may be positioned directly below the lower surface of the first superlattice layer 301. The third superlattice layer 303 may contact a lower surface of the first superlattice layer 301. Since the unit superlattice structure 310 is repeatedly stacked in the third direction (Z direction), the third superlattice layer 303 may be positioned on the second superlattice layer 302 of the unit superlattice structure 310 positioned below. For example, the superlattice structure 300 may have a structure in which the third superlattice layer 303, the first superlattice layer 301, and the second superlattice layer 302 are sequentially and repeatedly stacked in the third direction (Z direction). The third superlattice layer 303 may be positioned between the first superlattice layer 301 and the second superlattice layer 302. The third superlattice layer 303 may be positioned on the upper surface of the second superlattice layer 302.

With further reference to FIG. 9, the third superlattice layer 303 of the semiconductor device according to some implementations may include a first element and a second element. Here, the first element may be Si, and the second element may be C, but is not limited thereto. As an example, the first semiconductor layer 131, the first superlattice layer 301, the second superlattice layer 302, the third superlattice layer 303, and the second semiconductor layer 132 may be SiₐC₁₋ₐ (0<a<1). The third superlattice layer 303 has a third energy band gap BE3 determined by the content of the material forming the third superlattice layer 303.

In some implementations, the third energy band gap BE3 of the third superlattice layer 303 may be greater than the first energy band gap BE1 of the first superlattice layer 301, and may be less than the second energy band gap BE2 of the second superlattice layer 302. In this case as well, the second energy band gap BE2 of the second superlattice layer 302 may be substantially the same as the energy band gap of the first semiconductor layer 131. In some implementations, the second energy band gap BE2 of the second superlattice layer 302 may be substantially identical to the energy band gap of the second semiconductor layer 132. The first energy band gap BE1, the second energy band gap BE2, and the third energy band gap BE3 may have a substantially constant magnitude. However, example implementations are not limited thereto.

According to the implementation, the content N3 of the first element in the third superlattice layer 303 may be different from the content N1 of the first element in the first superlattice layer 301 and the content N2 of the first element in the second superlattice layer 302. For example, since the energy band gap tends to decrease as the content of the first element, which is a semiconductor element, increases, the content N3 of the first element in the third superlattice layer 303 may be less than the content N1 of the first element in the first superlattice layer 301. The content N3 of the first element of the third superlattice layer 303 may be greater than the content N2 of the first element of the second superlattice layer 302. The content of the second element in the third superlattice layer 303 may be greater than the content of the second element in the first superlattice layer 301. The content of the second element of the third superlattice layer 303 may be less than the content of the second element of the second superlattice layer 302. The content N2 of the first element of the second superlattice layer 302 may be substantially the same as the content of the first element of the first semiconductor layer 131, but is not limited thereto. Here, the first element may be Si, and the second element may be C; however, example implementations are not limited thereto.

The types and contents of the materials of the first superlattice layer 301, the second superlattice layer 302, and the third superlattice layer 303 may be variously changed within a range in which the third energy band gap BE3 is greater than the first energy band gap BE1 and less than the second energy band gap BE2. In an example implementation, the first superlattice layer 301 and the third superlattice layer 303 may further include a third element. Here, the third element may be Ge, but is not limited thereto. That is, the first superlattice layer 301 and the third superlattice layer 303 may be Si_{b}Ge_{c}C_{1-b-c} (0≤b≤1, 0<c≤1, b+c≤1), and the first semiconductor layer 131, the second superlattice layer 302, and the second semiconductor layer 132 may be SiₐC₁₋ₐ (0<a<1). As the content of the third element increases, the energy band gap tends to decrease. The content of the third element in the third superlattice layer 303 may be less than the content of the third element in the first superlattice layer 301. The content of the second element of the third superlattice layer 303 may be less than or equal to the content of the second element of the second superlattice layer 302. The content of the second element of the third superlattice layer 303 may be greater than or equal to the content of the second element of the first superlattice layer 301.

Even when the content of the second element in the third superlattice layer 303 is the same as the content of the second element in the second superlattice layer 302, the third superlattice layer 303 may include more of the third element, so that the third energy band gap BE3 may be less than the second energy band gap BE2. In this case, the content of the third element of the first superlattice layer 301 may be about 10 at% to about 50 at%, and the content of the third element of the third superlattice layer 303 may be about 5 at% to about 30 at%. In this range, an energy barrier may be formed by the energy band gap of the superlattice structure 300, and accordingly, movement of carriers of the reverse current may be suppressed, and movement of carriers of the driving current may be facilitated.

As another example, each of the first superlattice layer 301 to the third superlattice layer 303 may be Si_{b}Ge_{c}C_{1-b-c} (0≤b≤1, 0<c≤1, b+c≤1). In this case, the content of the third element in the third superlattice layer 303 may be greater than the content of the third element in the second superlattice layer 302. The content of the third element in the third superlattice layer 303 may be less than the content of the third element in the first superlattice layer 301. In some implementations, the content of the second element in the third superlattice layer 303 may be less than or equal to the content of the second element in the second superlattice layer 302. The content of the second element in the third superlattice layer 303 may be greater than or equal to the content of the second element in the first superlattice layer 301. Specifically, even when the content of the second element of the first superlattice layer 301, the content of the second element of the second superlattice layer 302, and the content of the second element of the third superlattice layer 303 are substantially the same, if the content of the third element of the third superlattice layer 303 is greater than the content of the third element of the second superlattice layer 302, and the content of the third element of the first superlattice layer 301 is greater than the content of the third element of the third superlattice layer 303, the third energy band gap BE3 may become greater than the first energy band gap BE1, and may become less than the second energy band gap BE2. Furthermore, even when the content N1 of the first element in the first superlattice layer 301, the content N2 of the first element in the second superlattice layer 302, and the content N3 of the first element in the third superlattice layer 303 are substantially the same, if the content of the third element in the first superlattice layer 301 is greater than the content of the third element in the third superlattice layer 303, and the content of the third element in the third superlattice layer 303 is greater than the content of the third element in the second superlattice layer 302, the third energy band gap BE3 may become greater than the first energy band gap BE1, and may become less than the second energy band gap BE2. In this case, the content of the third element of the first superlattice layer 301 may be about 10 at% to about 50 at%, and the content of the third element of the third superlattice layer 303 may be about 5 at% to about 30 at%. In this range, it is possible to prevent a decrease in the breakdown voltage of the semiconductor device due to the reduction in the energy band gap of the entire superlattice structure 300, while simultaneously preventing an increase in the operating voltage of the semiconductor device.

As another example, in an example implementation, the first element includes Ga, the second element may include N, and the third element may also include In. The first superlattice layer 301 and the third superlattice layer 303 may be In_{y}Ga_{1-y}N (0≤y≤1), and the second superlattice layer 302 may be GaN. In some implementations, the first semiconductor layer 131 and the second semiconductor layer 132 may be made of GaN. In this case as well, the tendency is that as the content of the third element increases, the energy band gap decreases. Therefore, as the first superlattice layer 301 and the third superlattice layer 303 include In, the third energy band gap BE3 may be greater than the first energy band gap BE1 and may be less than the second energy band gap BE2.

In summary, the unit superlattice structure 310 of a semiconductor device according to some implementations may include a first superlattice layer 301 to a third superlattice layer 303 having different energy band gaps. The third superlattice layer 303, the first superlattice layer 301, and the second superlattice layer 302 are sequentially and repeatedly stacked in the third direction (Z direction), and the third energy band gap BE3 of the third superlattice layer 303 may be greater than the first energy band gap BE1 of the first superlattice layer 301 and may have a range less than the second energy band gap BE2 of the second superlattice layer 302. Accordingly, when a carrier moves in the +Z direction, a reverse energy barrier REG may be formed between the first superlattice layer 301 and the second superlattice layer 302. On the other hand, when a carrier moves in the -Z direction, a first forward energy barrier FEG1 is formed between the first superlattice layer 301 and the third superlattice layer 303, and a second forward energy barrier FEG2 may be formed between the second superlattice layer 302 and the third superlattice layer 303. The sum of the first forward energy barrier FEG1 and the second forward energy barrier FEG2 is equal to the reverse energy barrier REG.

In some implementations, the movement direction RC of carriers of the reverse current RI of FIG. 4 may be the +Z direction, and the movement direction FC of carriers of the driving current FI of FIG. 4 may be the -Z direction. Therefore, when the carrier of the reverse current moves in the +Z direction, the movement of the carrier in the +Z direction may be suppressed by a relatively high reverse energy barrier REG. On the other hand, when the carrier of the driving current moves in the -Z direction, it may be possible to prevent the movement of the carrier in the -Z direction from being inhibited by the relatively low first forward energy barrier FEG1 and second forward energy barrier FEG2.

In other words, the carrier may have different barrier heights according to the moving direction within the superlattice structure 300. The carrier may have its movement in the +Z direction relatively suppressed within the superlattice structure 300, and may remain within the first superlattice layer 301 to the third superlattice layer 303 or may diffuse in a horizontal direction (for example, the first direction (X direction) and/or the second direction (Y direction)). Therefore, while maintaining the flow of driving current FI of FIG. 4 of the semiconductor device according to one implementation, the flow of reverse current RI of FIG. 4 may be reduced. Accordingly, the breakdown voltage characteristic of the semiconductor device may be improved, and the reliability of the semiconductor device may be enhanced.

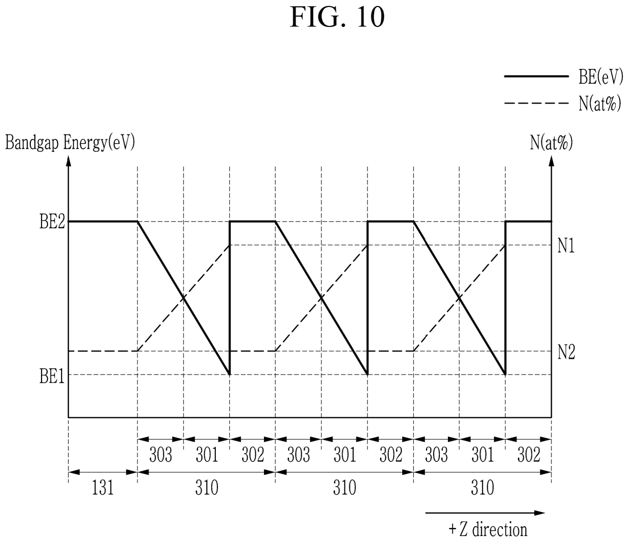

Referring to FIG. 10, the unit superlattice structure 310 of the semiconductor device according to some implementations may include a portion in which the energy band gap decreases as it becomes farther from the upper surface of the first semiconductor layer 131. For example, the energy band gap of the third superlattice layer 303 may decrease as it becomes farther from the upper surface of the first semiconductor layer 131. The energy band gap of the third superlattice layer 303 may have a minimum value at a point adjacent to the first superlattice layer 301. In some implementations, the energy band gap of the first superlattice layer 301 may decrease as it becomes farther from the upper surface of the first semiconductor layer 131. The energy band gap of the first superlattice layer 301 may have a maximum value at a point adjacent to the third superlattice layer 303, and may have a minimum value at a point adjacent to the second superlattice layer 302. A change in the energy band gap in the third superlattice layer 303 and the first superlattice layer 301 may have a continuous value, but is not limited thereto. For example, the change in energy band gap of the third superlattice layer 303 according to distance and the change in energy band gap of the first superlattice layer 301 according to distance may be constant, but are not limited thereto.

In the case of the implementation of FIG. 10, when the carrier of the reverse current moves in the +Z direction, the movement of the carrier in the +Z direction may be suppressed by a relatively high reverse energy barrier. On the other hand, when the carrier of the driving current moves in the -Z direction, it may be possible to prevent suppression of the carrier movement in the -Z direction due to relatively low forward energy barriers formed continuously. Therefore, while maintaining the flow of the driving current FI of FIG. 4 of the semiconductor device according to one implementation, the flow of the reverse current RI of FIG. 4 may be reduced. Accordingly, the breakdown voltage characteristics of the semiconductor device may be improved, and the reliability of the semiconductor device may be enhanced.

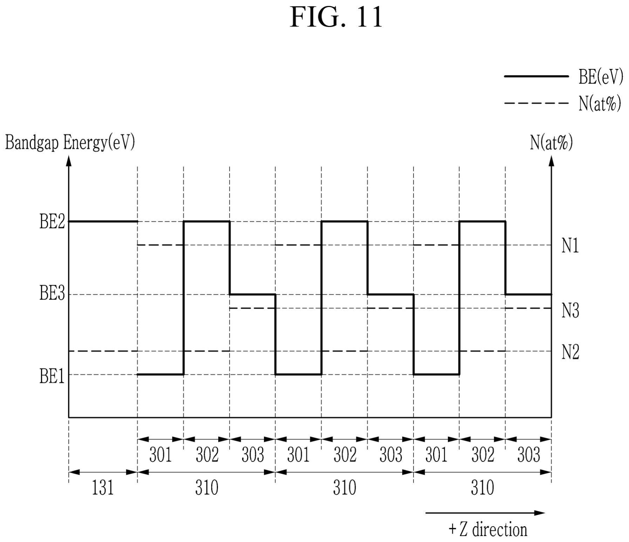

The arrangement relationship of the first superlattice layer 301 to the third superlattice layer 303 may be variously changed. For example, as shown in FIG. 11, in the unit superlattice structure 310, the third superlattice layer 303 may be positioned on the second superlattice layer 302. The unit superlattice structure 310 is repeatedly stacked in the third direction (Z direction), so the third superlattice layer 303 may be positioned below the first superlattice layer 301 of the unit superlattice structure 310 positioned above. That is, the superlattice structure 300 may have a structure in which the first superlattice layer 301, the second superlattice layer 302, and the third superlattice layer 303 are sequentially and repeatedly stacked in the third direction (Z direction).

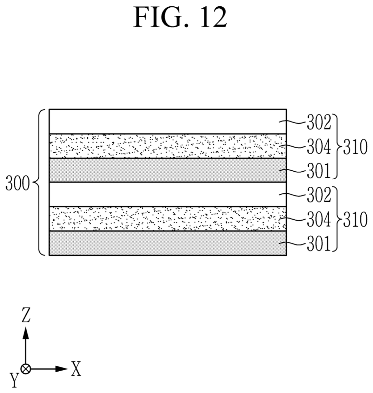

Hereinafter, with reference to FIGS. 12 to 14, a superlattice structure of a semiconductor device according to some implementations will be described.

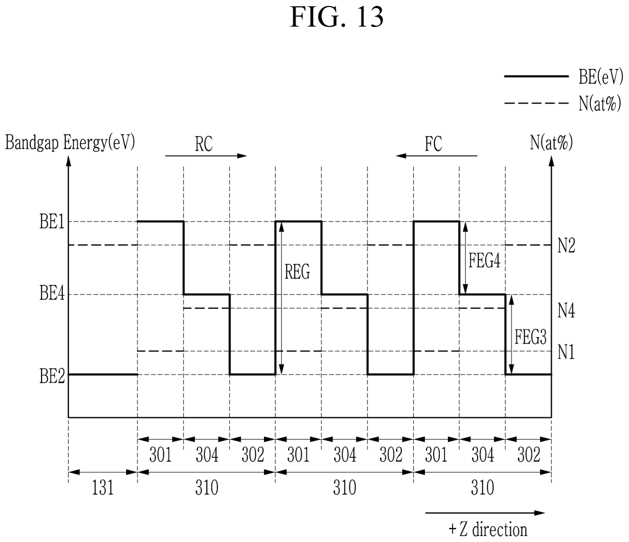

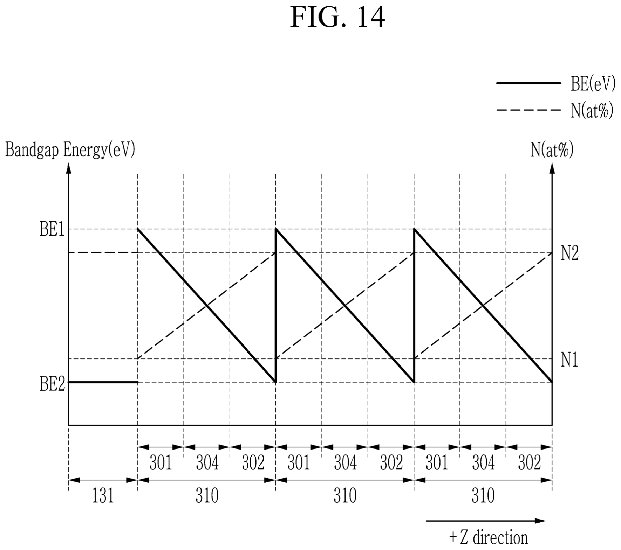

FIG. 12 is a cross-sectional view showing a superlattice structure of a semiconductor device according to some implementations. FIG. 13 and FIG. 14 are graphs illustrating the content of materials forming the first semiconductor layer and the superlattice structure of a semiconductor device according to some implementations.

FIGS. 12 to 14 illustrate various modifications of the semiconductor device according to an implementation shown in FIGS. 6 and 7. FIGS. 12 to 14 illustrate implementations in which the parts that are the same as those of the implementations shown in FIGS. 6 and 7 are substantial, and thus a description thereof is omitted and the differences will be mainly described. In addition, the same reference numerals are used for the same components as in the previous implementation.

Referring to FIG. 12, the unit superlattice structure 310 of the semiconductor device according to some implementations may further include a fourth superlattice layer 304 positioned between the first superlattice layer 301 and the second superlattice layer 302.

In the unit superlattice structure 310, the fourth superlattice layer 304 may be positioned on the first superlattice layer 301. A lower surface of the fourth superlattice layer 304 may be in contact with the first superlattice layer 301, and an upper surface of the fourth superlattice layer 304 may be in contact with the second superlattice layer 302. That is, since the unit superlattice structure 310 is stacked repeatedly in the third direction (Z direction), the superlattice structure 300 may have a structure in which the first superlattice layer 301, the fourth superlattice layer 304, and the second superlattice layer 302 are sequentially stacked repeatedly in the third direction (Z direction).

Referring further to FIG. 13, in some implementations, the fourth superlattice layer 304 of another semiconductor device may include the first element and the second element. Here, the first element may be Si, and the second element may be C, but is not limited thereto. As an example, the first semiconductor layer 131, the first superlattice layer 301, the second superlattice layer 302, the fourth superlattice layer 304, and the second semiconductor layer 132 may be SiₐC₁₋ₐ (0<a<1). The fourth superlattice layer 304 has a fourth energy band gap BE4 determined by the content of the material forming the fourth superlattice layer 304.

In some implementations, the fourth energy band gap BE4 of the fourth superlattice layer 304 may be less than the first energy band gap BE1 of the first superlattice layer 301 and may be greater than the second energy band gap BE2 of the second superlattice layer 302. In this case as well, the second energy band gap BE2 of the second superlattice layer 302 may be substantially the same as the energy band gap of the first semiconductor layer 131. In some implementations, the second energy band gap BE2 of the second superlattice layer 302 may be substantially equal to the energy band gap of the second semiconductor layer 132. Accordingly, the fourth energy band gap BE4 and the first energy band gap BE1 may be greater than the energy band gap of the first semiconductor layer 131. The first energy band gap BE1, the second energy band gap BE2, and the fourth energy band gap BE4 may have a substantially constant magnitude; however, the disclosure is not limited thereto.

According to the implementation, the content N4 of the first element of the fourth superlattice layer 304 may be different from the content N1 of the first element of the first superlattice layer 301 and the content N2 of the first element of the second superlattice layer 302. For example, as the content of the first element, which is a semiconductor element, increases, there is a tendency for the energy band gap to become smaller; thus, the content N4 of the first element in the fourth superlattice layer 304 may be greater than the content N1 of the first element in the first superlattice layer 301. The content N4 of the first element of the fourth superlattice layer 304 may be less than the content N2 of the first element of the second superlattice layer 302. The content of the second element in the fourth superlattice layer 304 may be less than the content of the second element in the first superlattice layer 301. The content of the second element of the fourth superlattice layer 304 may be greater than the content of the second element of the second superlattice layer 302. The content N2 of the first element in the second superlattice layer 302 may be substantially the same as the content of the first element in the first semiconductor layer 131, but is not limited thereto. Here, the first element may be Si, and the second element may be C, but is not limited thereto.

The types and contents of materials of the first superlattice layer 301, the second superlattice layer 302, and the fourth superlattice layer 304 may be variously changed within a range in which the fourth energy band gap BE4 is less than the first energy band gap BE1, and greater than the second energy band gap BE2. In an example implementation, the first superlattice layer 301 and the fourth superlattice layer 304 may further include a third element. Here, the first element includes Ga, the second element may include N, and the third element may include Al. That is, the first superlattice layer 301 and the fourth superlattice layer 304 may be Al_{z}Ga_{1-z}N (0≤Z≤1), and the second superlattice layer 302 may be GaN. In some implementations, the first semiconductor layer 131 and the second semiconductor layer 132 may be formed of GaN. In this case, as the content of the third element increases, the energy band gap tends to increase. The content of the third element in the first superlattice layer 301 may be greater than the content of the third element in the fourth superlattice layer 304. Therefore, as the first superlattice layer 301 and the fourth superlattice layer 304 include Al, the fourth energy band gap BE4 may become greater than the second energy band gap BE2 and may become less than the first energy band gap BE1.

Referring to FIG. 14, the unit superlattice structure 310 of a semiconductor device according to some implementations may include a portion in which the energy band gap decreases as it becomes farther from the upper surface of the first semiconductor layer 131. For example, the energy band gap of the fourth superlattice layer 304 may decrease as it becomes farther from the upper surface of the first semiconductor layer 131. The energy band gap of the fourth superlattice layer 304 may have a maximum value at the point adjacent to the first superlattice layer 301. In some implementations, the energy band gap of the first superlattice layer 301 may decrease as it becomes farther from the upper surface of the first semiconductor layer 131. The energy band gap of the first superlattice layer 301 may have a minimum value at a point adjacent to the fourth superlattice layer 304. The change in energy band gap in the fourth superlattice layer 304 and the first superlattice layer 301 may have a continuous value, but is not limited thereto. For example, the amount of change in the energy band gap of the fourth superlattice layer 304 according to distance and the amount of change in the energy band gap of the first superlattice layer 301 according to distance may be constant; however, it is not limited thereto.

In the cases of the implementations of FIGS. 12 to 14 and in the case of the implementation of FIG. 10, when the carrier of the reverse current moves in the +Z direction, the movement of the carrier in the +Z direction may be suppressed by a relatively high reverse energy barrier REG. On the other hand, when the carrier of the driving current moves in the -Z direction, it may be possible to prevent the movement of the carrier in the -Z direction from being suppressed by the relatively low third forward energy barrier FEG3 and fourth forward energy barrier FEG4. Therefore, it may be possible to reduce the flow of the reverse current RI of FIG. 4, while maintaining the flow of the driving current FI of FIG. 4 of the semiconductor device according to an implementation. Accordingly, the breakdown voltage characteristic of the semiconductor device may be improved, and the reliability of the semiconductor device may be enhanced.

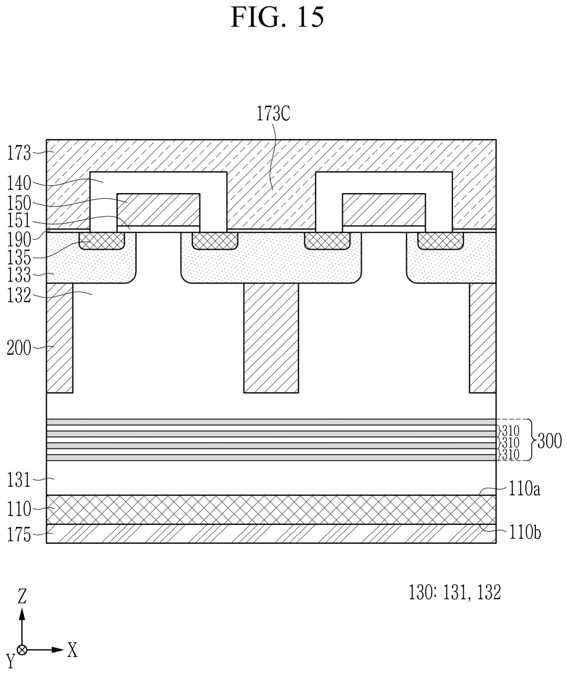

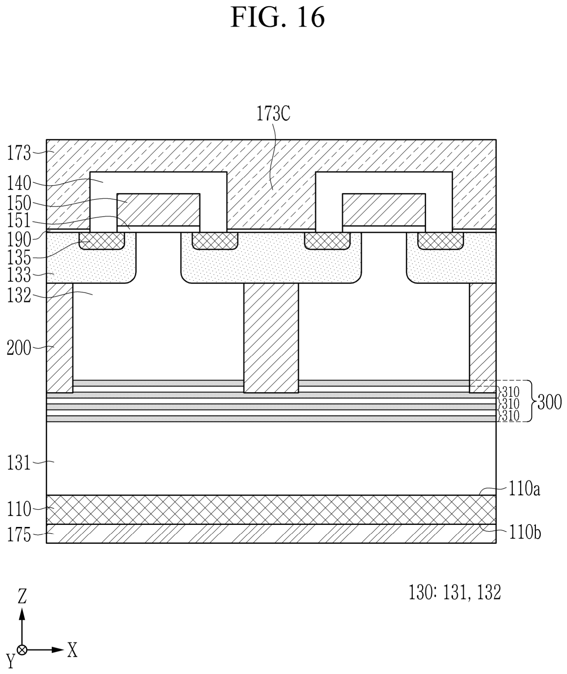

Hereinafter, with reference to FIG. 15 and FIG. 16, a superlattice structure of a semiconductor device according to some implementations will be described.

FIG. 15 and FIG. 16 are cross-sectional views illustrating a semiconductor device according to some implementations.

FIG. 15 and FIG. 16 illustrate various modifications of the semiconductor device according to the implementations shown in FIGS. 1 to 14. FIGS. 15 and 16 illustrate implementations that are substantially the same as the implementations shown in FIGS. 1 to 14, so a description thereof will be omitted and the differences will mainly be described. In addition, the same reference numerals are used for the same components as in the previous implementation.

Referring to FIG. 15, the pillar layer 200 of the semiconductor device according to some implementations may be positioned within the second semiconductor layer 132. Both side surfaces and the lower surface of the pillar layer 200 may be surrounded by the second semiconductor layer 132. The pillar layer 200 may be positioned on the superlattice structure 300. The superlattice structure 300 may be positioned spaced apart from the pillar layer 200 in the third direction (Z direction). The distance between the upper surface of the superlattice structure 300 and the first surface 110a of the substrate 110 may be less than the distance between the lower surface of the pillar layer 200 and the first surface 110a of the substrate 110.

Referring to FIG. 16, the pillar layer 200 may penetrate a portion of the superlattice structure 300. The pillar layer 200 may be positioned in a space in which at least a portion of the superlattice structure 300 is recessed. The pillar layer 200 may overlap with the superlattice structure 300 in the first direction (X direction). The distance between the upper surface of the superlattice structure 300 and the first surface 110a of the substrate 110 may be greater than the distance between the lower surface of the pillar layer 200 and the first surface 110a of the substrate 110. In this case, the distance between the lower surface of the superlattice structure 300 and the first surface 110a of the substrate 110 may be less than the distance between the lower surface of the pillar layer 200 and the first surface 110a of the substrate 110.

Hereinafter, superlattice structures of a semiconductor device according to several implementations will be described with reference to FIGS. 17 to 19.

FIGS. 17 to 19 are cross-sectional views showing semiconductor devices according to some implementations.

FIGS. 17 to 19 illustrate various modifications of the semiconductor device according to the implementations shown in FIGS. 1 to 14. The implementations shown in FIGS. 17 to 19 are substantially similar to the implementations shown in FIGS. 1 to 14, and thus, descriptions thereof will be omitted and differences will be mainly described. In addition, the same reference numerals are used for components identical to those in the previous implementation.

Referring to FIGS. 17 to 19, a semiconductor device according to some implementations may be an insulated gate bipolar transistor (IGBT).

A semiconductor device according to several implementations includes a semiconductor layer 130_1 including a first semiconductor layer 131_1 and a second semiconductor layer 132_1, a superlattice structure 300_1 positioned on the first semiconductor layer 131_1, a second semiconductor layer 132_1 positioned on the superlattice structure 300_1, a doped well region 133_1 positioned within the second semiconductor layer 132_1, a first doped layer 135_1 and a second doped layer 139 positioned within the doped well region 133_1, a gate electrode 150_1 positioned adjacent to the doped well region 133_1, a gate insulating layer 151_1 positioned between the gate electrode 150_1 and the doped well region 133_1, a first electrode 173 positioned on the first doped layer 135_1, and a second electrode 175 positioned on a lower surface of the first semiconductor layer 131_1.

The superlattice structure 300_1 may be positioned between the first semiconductor layer 131_1 and the second semiconductor layer 132_1. The superlattice structure 300_1 may be positioned on the first semiconductor layer 131_1. The superlattice structure 300_1 may contact an upper surface of the first semiconductor layer 131_1. The superlattice structure 300_1 may include at least one unit superlattice structure 310_1.

A semiconductor device according to some implementations may further include a gate trench 160 penetrating at least a portion of the second semiconductor layer 132_1 and the unit superlattice structure 310_1. The gate trench 160 may penetrate the first doped layer 135_1, the doped well region 133_1, the second semiconductor layer 132_1, and the superlattice structure 300_1. The gate trench 160 may be positioned within a space where at least a portion of the first semiconductor layer 131_1 is recessed. The inner wall of the gate trench 160 may be defined by the first doped layer 135_1, the doped well region 133_1, the second semiconductor layer 132_1, the superlattice structure 300_1, and the first semiconductor layer 131_1. The bottom surface of the gate trench 160 may be defined by the first semiconductor layer 131_1.

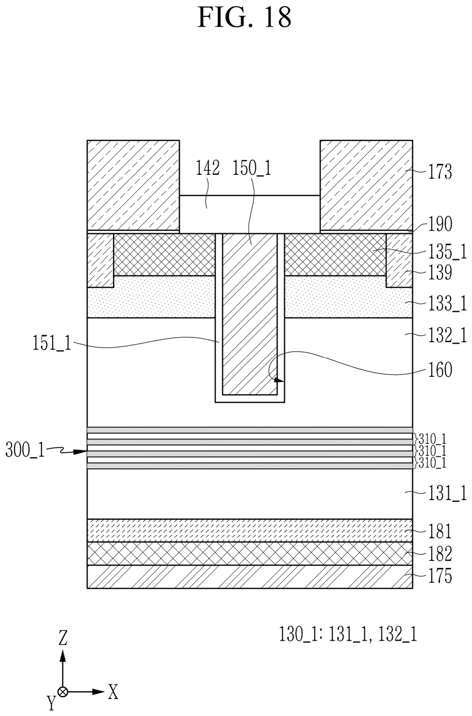

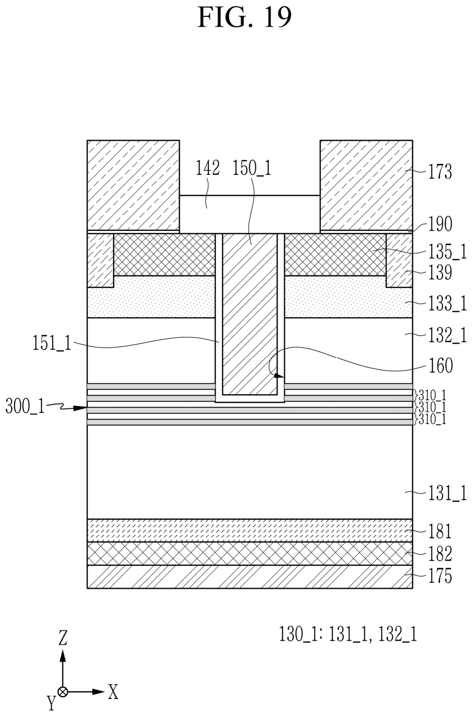

The gate trench 160 may completely penetrate the superlattice structure 300_1. The distance between the bottom surface of the gate trench 160 and the lower surface of the first semiconductor layer 131_1 may be less than the distance between the lower surface of the superlattice structure 300_1 and the lower surface of the first semiconductor layer 131_1. However, example implementations are not limited thereto, and as another example, as illustrated in FIG. 18, the gate trench 160 may be positioned within the second semiconductor layer 132_1. The gate trench 160 may be positioned on the superlattice structure 300_1. In this case, the gate trench 160 may be non-overlapping with the unit superlattice structure 310_1 in the first direction (X direction). A distance between a bottom surface of the gate trench 160 and a lower surface of the first semiconductor layer 131_1 may be greater than a distance between a lower surface of the superlattice structure 300_1 and the lower surface of the first semiconductor layer 131_1. As another example, as shown in FIG. 19, the gate trench 160 may penetrate at least a portion of the superlattice structure 300_1. The gate trench 160 may penetrate at least a portion of the unit superlattice structure 310_1. The distance between the bottom surface of the gate trench 160 and the lower surface of the first semiconductor layer 131_1 may be greater than the distance between the lower surface of the superlattice structure 300_1 and the lower surface of the first semiconductor layer 131_1. The distance between the bottom surface of the gate trench 160 and the lower surface of the first semiconductor layer 131_1 may be less than the distance between the upper surface of the superlattice structure 300_1 and the lower surface of the first semiconductor layer 131_1.

In some implementations, the gate electrode 150_1 may be positioned in the gate trench 160. The gate electrode 150_1 may overlap the superlattice structure 300_1 in the first direction (X direction). The distance between the lower surface of the gate electrode 150_1 and the lower surface of the first semiconductor layer 131_1 may be less than the distance between the lower surface of the superlattice structure 300_1 and the lower surface of the first semiconductor layer 131_1, but is not limited thereto.

The gate insulating layer 151_1 may be positioned between the gate electrode 150_1 and the doped well region 133_1, and between the gate electrode 150_1 and the unit superlattice structure 310_1. The gate insulating layer 151_1 may be in contact with the side surface of the unit superlattice structure 310_1. In some implementations, the gate insulating layer 151_1 may be positioned between the gate electrode 150_1 and the first semiconductor layer 131_1, and between the gate electrode 150_1 and the second semiconductor layer 132_1.

A semiconductor device according to some implementations may further include a third semiconductor layer 181 positioned between the first semiconductor layer 131_1 and the second electrode 175, and a fourth semiconductor layer 182 positioned between the third semiconductor layer 181 and the second electrode 175.

The third semiconductor layer 181 may be positioned between the first semiconductor layer 131_1 and the fourth semiconductor layer 182. The third semiconductor layer 181 may have a second conductivity type. The third semiconductor layer 181 may be doped with the second conductivity type impurity. For example, the second conductivity type impurity may be a p-type impurity. The fourth semiconductor layer 182 may be positioned between the third semiconductor layer 181 and the second electrode 175. The fourth semiconductor layer 182 may have the first conductivity type. The fourth semiconductor layer 182 may be doped with a first conductivity type impurity. For example, the first conductivity type impurity may be an n-type impurity.

In some implementations, a substrate may be further positioned between the first semiconductor layer 131_1 and the third semiconductor layer 181, between the third semiconductor layer 181 and the fourth semiconductor layer 182, or between the fourth semiconductor layer 182 and the second electrode 175. In this case, the substrate may be a semiconductor substrate including SiC. For example, the substrate may be formed of a 4H SiC substrate. In some cases, the substrate may be formed of a 3C SiC substrate, a 6H SiC substrate, and the like. The substrate may have a second conductivity type. The substrate may be doped with a low concentration having the second conductivity type.

A semiconductor device according to some implementations may further include a capping layer 142 positioned on the gate electrode 150_1. The capping layer 142 may cover the upper surface of the gate electrode 150_1. The capping layer 142 may include various insulating materials.

A semiconductor device according to some implementations may be an IGBT. The third semiconductor layer 181, the first semiconductor layer 131_1, the second semiconductor layer 132_1, and the doped well region 133_1 may constitute a BJT having a PNP structure. In this case, the first semiconductor layer 131_1 and the second semiconductor layer 132_1 may be the base region of the BJT (bipolar junction transistor). The first semiconductor layer 131_1, the second semiconductor layer 132_1, the gate electrode 150_1, and the first doped layer 135_1 may constitute a MOSFET. The first doped layer 135_1 may be a source region of the MOSFET, and the first semiconductor layer 131_1 and the second semiconductor layer 132_1 may be drain regions of the MOSFET. The doped well region 133_1 may be a channel region. In some implementations, the first electrode 173 may be an emitter electrode of the IGBT, and the second electrode 175 may be a collector electrode of the IGBT.

The driving current may be formed from the second electrode 175 toward the first electrode 173. In the case of the implementations of FIGS. 17 to 19, a reverse current may be generated from the first electrode 173 toward the second electrode 175. A semiconductor device according to some implementations includes at least one unit superlattice structure 310_1 between the first semiconductor layer 131_1 and the second semiconductor layer 132_1. Therefore, the movement of carriers in the +Z direction may be suppressed by an energy barrier formed within the unit superlattice structure 310_1, and the carriers may remain within the unit superlattice structure 310_1 or diffuse in the horizontal direction (for example, the first direction (X direction) and/or the second direction (Y direction)). That is, due to the effect of suppression of carrier movement in the +Z direction, the occurrence of reverse current may be reduced. Therefore, the leakage current of the semiconductor device according to one implementation may be reduced, and the breakdown voltage characteristics may be improved. Accordingly, the reliability of the semiconductor device according to some implementations may be enhanced.

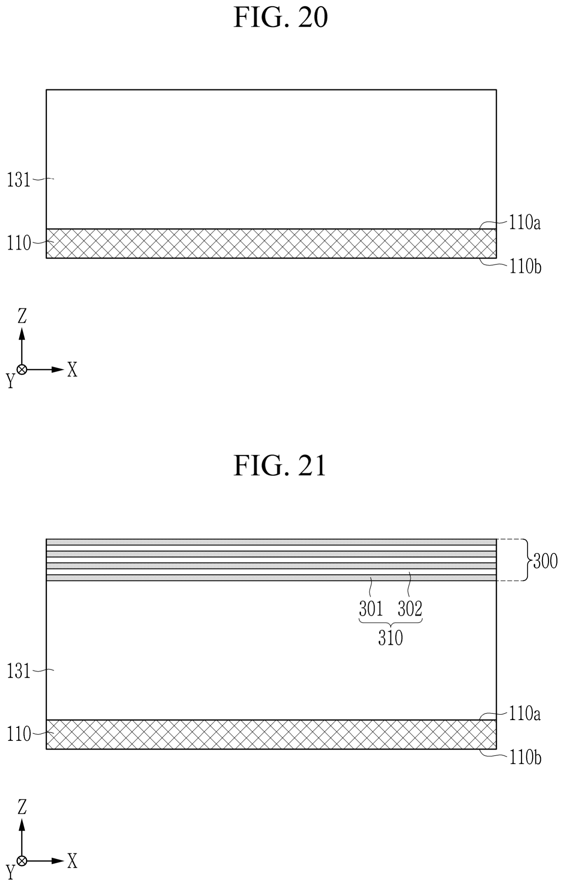

Hereinafter, a method of manufacturing a semiconductor device according to one implementation will be described with reference to FIGS. 20 to 26.

FIGS. 20 to 26 are process cross-sectional views of intermediate steps illustrating a method of manufacturing a semiconductor device according to an implementation.

Referring to FIG. 20, a first semiconductor layer 131 may be formed on the substrate 110.

The substrate 110 may be a semiconductor substrate including SiC. For example, the substrate 110 may be formed of a 4H SiC substrate. In some cases, the substrate 110 may be formed of a 3C SiC substrate, a 6H SiC substrate, or the like. The substrate 110 may be doped with a first conductivity type impurity. For example, the first conductivity type impurity may be an n-type impurity. In other words, the substrate 110 may be doped with n-type. The substrate 110 may be heavily doped with n-type. The resistivity of the substrate 110 may be about 0.005 Ωcm or more and about 0.035 Ωcm or less. The thickness of the substrate 110 may be about 10 µm or more and about 700 µm or less. The material, doping type, doping concentration, resistivity, thickness, and the like of the substrate 110 are not limited thereto, and may be variously changed.

The substrate 110 may include a first surface 110a and a second surface 110b opposite each other. For example, the first surface 110a of the substrate 110 may refer to an upper surface of the substrate 110, and the second surface 110b of the substrate 110 may refer to a lower surface of the substrate 110.

The first semiconductor layer 131 may be formed on the substrate 110. The first semiconductor layer 131 may be positioned on the first surface 110a, that is, the upper surface of the substrate 110. A lower surface of the first semiconductor layer 131 may be in contact with the first surface 110a of the substrate 110. However, example implementations are not limited thereto, and an additional predetermined layer may be further positioned between the substrate 110 and the first semiconductor layer 131. The first semiconductor layer 131 may be an epitaxy layer formed on the substrate 110 by using epitaxial growth. The first semiconductor layer 131 may include SiC. For example, the first semiconductor layer 131 may include 4H SiC. The first semiconductor layer 131 may have a first conductivity type. The first semiconductor layer 131 may be doped to an n-type. The first semiconductor layer 131 may be doped with a low concentration as an n-type. The doping concentration of the first semiconductor layer 131 may be lower than the doping concentration of the substrate 110. The doping concentration of the first semiconductor layer 131 may be about 1*10¹⁵cm⁻³ or more and about 1*10¹⁷cm⁻³ or less. The thickness of the first semiconductor layer 131 may be about 1 µm or more and about 13 µm or less.

Referring to FIG. 21, a superlattice structure 300 including at least one unit superlattice structure 310 may be formed by alternately forming a first superlattice layer 301 and a second superlattice layer 302 on the first semiconductor layer 131.

The superlattice structure 300 may include at least one unit superlattice structure 310. For example, the superlattice structure 300 may include two or more unit superlattice structures 310. At least one unit superlattice structure 310 may be stacked on the first semiconductor layer 131 in the third direction (Z direction). Accordingly, the superlattice structure 300 may have a structure in which the unit superlattice structure 310 is stacked repeatedly in the third direction (Z direction). The number of unit superlattice structures 310 may be variously changed and is not limited thereto.

The unit superlattice structure 310 may include a plurality of superlattice layers 301, 302 having different energy band gaps. For example, the unit superlattice structure 310 may include a first superlattice layer 301 and a second superlattice layer 302 positioned on the first superlattice layer 301. Accordingly, the superlattice structure 300 may have a structure in which a plurality of superlattice layers 301, 302 are alternately stacked.

The superlattice structure 300 may be an epitaxy layer formed using epitaxial growth from the first semiconductor layer 131. The superlattice structure 300 may include the same semiconductor material as the first semiconductor layer 131 and the second semiconductor layer 132 to be described later. For example, the superlattice structure 300 may be SiₐC₁₋ₐ (0<a<1). In this case, the superlattice structure 300 may be constituted by a plurality of layers having different Si contents. Specifically, the first superlattice layer 301 and the second superlattice layer 302 may include the first element and the second element. Here, the first element may be Si, and the second element may be C, but is not limited thereto. In this case, the semiconductor material forming the first superlattice layer 301 may have a first energy band gap BE1 (see FIG. 3), and the semiconductor material forming the second superlattice layer 302 may have a second energy band gap BE2 (see FIG. 3).

In another example, the superlattice structure 300 may be Si_{b}Ge_{c}C_{1-b}. _{c}/SiₐC₁₋ₐ (0<a<1, 0≤b≤1, 0<c≤1, b+c≤1). The superlattice structure 300 may have a structure in which a layer consisting of Si_{b}Ge_{c}C_{1-b-c} and a layer consisting of SiₐC₁₋ₐ are alternately stacked repeatedly.

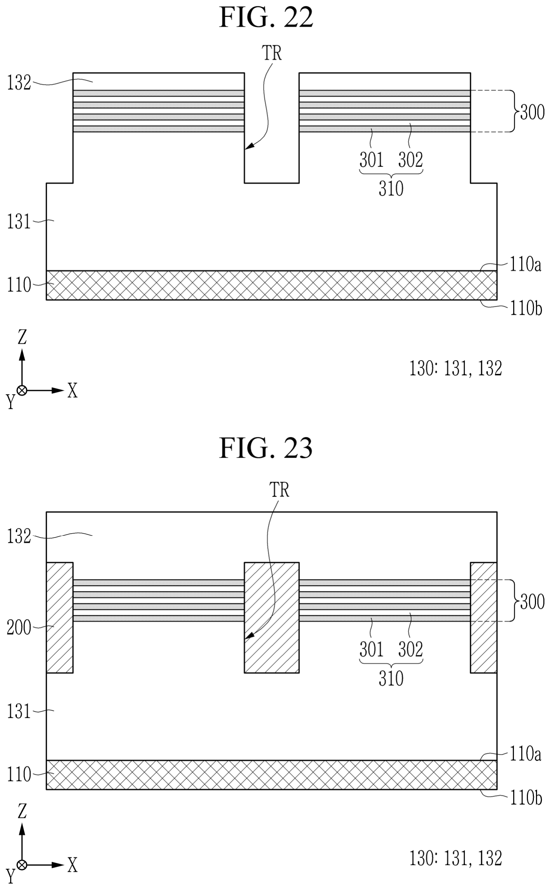

Referring to FIG. 22, at least a portion of the second semiconductor layer 132 may be formed on the superlattice structure 300, and a trench TR penetrating the superlattice structure 300 may be formed. The trench TR may be formed in the first semiconductor layer 131. The trench TR may extend in the third direction (Z direction). The trench TR may penetrate at least a portion of the second semiconductor layer 132 and the superlattice structure 300. An inner wall of the trench TR may be defined by the second semiconductor layer 132, the superlattice structure 300, and the first semiconductor layer 131. The bottom surface of the trench TR may be defined by the first semiconductor layer 131. The bottom surface of the trench TR may be positioned spaced apart from the first surface 110a of the substrate 110. The trench TR may be a region in which the pillar layer 200 is formed.

Referring to FIG. 23, a pillar layer 200 may be formed in the trench TR, and a second semiconductor layer 132 may be formed on the pillar layer 200.

The pillar layer 200 may penetrate the unit superlattice structure 310. For example, the pillar layer 200 may penetrate the superlattice structure 300. A side surface of the pillar layer 200 may be in contact with the unit superlattice structure 310. The superlattice structure 300 may be separated from each other in a first direction (X direction) by the pillar layer 200. The lower surface of the pillar layer 200 may be positioned at a lower level than the lower surface of the superlattice structure 300. The distance between the lower surface of the pillar layer 200 and the first surface 110a of the substrate 110 may be less than or equal to the distance between the lower surface of the superlattice structure 300 and the first surface 110a of the substrate 110, but is not limited thereto. The pillar layer 200 may overlap the second semiconductor layer 132, the superlattice structure 300, and the first semiconductor layer 131 in the first direction (X direction).

The second semiconductor layer 132 may be positioned on the superlattice structure 300 and the pillar layer 200. The second semiconductor layer 132 may be an epitaxy layer formed from the superlattice structure 300 by using epitaxial growth. The second semiconductor layer 132 may include the same material as the first semiconductor layer 131. For example, the second semiconductor layer 132 may include SiC. The second semiconductor layer 132 may include 4H SiC. The second semiconductor layer 132 may have a first conductivity type. The second semiconductor layer 132 may be doped with a first conductivity type impurity. For example, the first conductivity type impurity may be an n-type impurity. The second semiconductor layer 132 may be doped with a low concentration as n-type. The doping concentration of the second semiconductor layer 132 may be substantially equal to the doping concentration of the first semiconductor layer 131, but is not limited thereto.

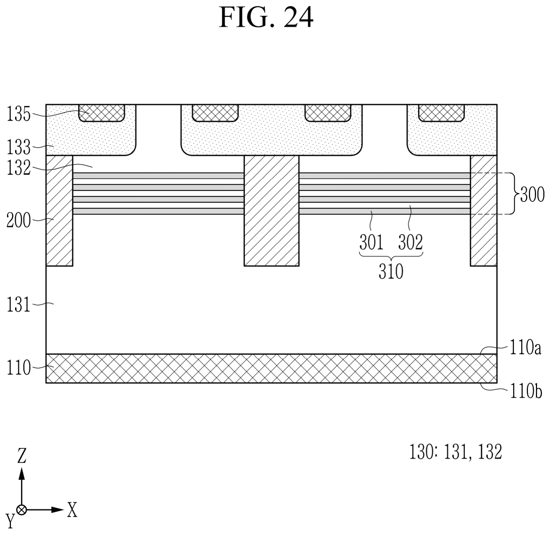

Referring to FIG. 24, a doped well region 133 may be formed in the second semiconductor layer 132, and a first doped layer 135 may be formed in the doped well region 133.

First, a doped well region 133 may be formed on the pillar layer 200. The doped well region 133 may be positioned within the second semiconductor layer 132. The doped well region 133 may be positioned on an upper portion of the second semiconductor layer 132. The doped well region 133 may extend from the upper surface of the second semiconductor layer 132 toward the lower surface of the second semiconductor layer 132. That is, the doped well region 133 may extend in a third direction (Z direction) from the upper surface of the second semiconductor layer 132. The doped well region 133 may be formed in at least a portion of the second semiconductor layer 132 by an ion implantation method; however, it is not limited thereto.

Subsequently, a first doped layer 135 may be formed in the doped well region 133. The first doped layer 135 may be embedded in the doped well region 133.

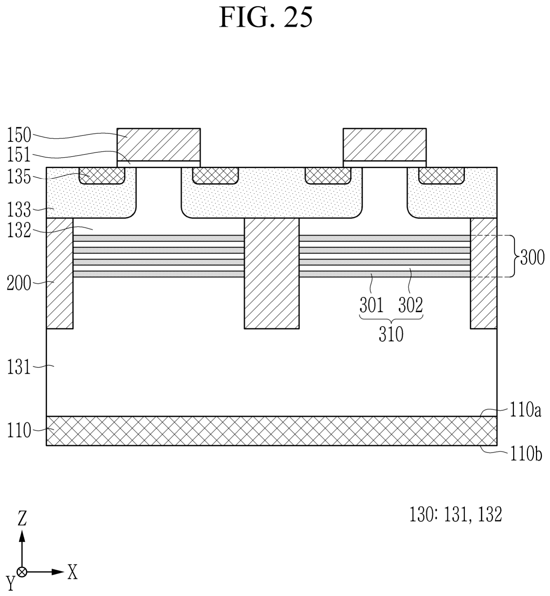

Referring to FIG. 25, a gate insulating layer 151 and a gate electrode 150 may be formed on the second semiconductor layer 132.

The gate insulating layer 151 may be formed on the second semiconductor layer 132. The thickness of the gate insulating layer 151 may be substantially uniform. In one implementation, the gate insulating layer 151 may overlap the doped well region 133 in the third direction (Z direction). The lower surface of the gate insulating layer 151 may contact the doped well region 133, but is not limited thereto.

The gate electrode 150 may be positioned on the gate insulating layer 151. The gate electrode 150 may be positioned on the second semiconductor layer 132. The gate electrode 150 may be positioned on the doped well region 133 and the first doped layer 135. The gate electrode 150 may be spaced apart from the second semiconductor layer 132. For example, the gate electrode 150 may be spaced apart from the second semiconductor layer 132 in the third direction (Z direction) by the gate insulating layer 151. A semiconductor device according to an implementation may have a planar gate structure. For example, in the semiconductor device according to the implementation, the gate electrode 150 has a flat plate shape having flat upper and lower surfaces, and the lower surface of the gate electrode 150 may be positioned at a level higher than the topmost surface of the second semiconductor layer 132. However, example implementations are not limited thereto, and the semiconductor device according to the implementation may have a gate structure in the form of a trench.

The method of manufacturing a semiconductor device according to one implementation may further include a step of forming an interlayer insulating layer 140 on the gate electrode 150. The interlayer insulating layer 140 may be positioned on the second semiconductor layer 132. The interlayer insulating layer 140 may be positioned on the gate electrode 150. Specifically, the interlayer insulating layer 140 may cover the upper surface and a side surface of the gate electrode 150. The interlayer insulating layer 140 may cover the side surface of the gate insulating layer 151. The interlayer insulating layer 140 may be positioned over at least a portion of the doped well region 133. The interlayer insulating layer 140 may have a lower surface contacting at least a portion of an upper surface of the doped well region 133.

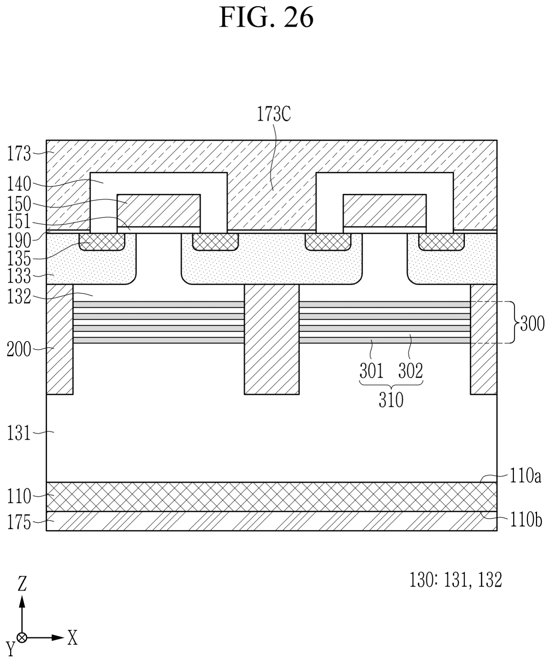

Referring to FIG. 26, a first electrode 173 may be formed on the doped well region 133, and a second electrode 175 may be formed on the lower surface of the first semiconductor layer 131.

The first electrode 173 may be positioned on the first doped layer 135. The first electrode 173 may be electrically connected to the doped well region 133 through the first doped layer 135. In this case, a silicide layer 190 may further be formed between the first electrode 173 and the doped well region 133, and between the first electrode 173 and the first doped layer 135. A second electrode 175 may be formed on the second surface 110b of the substrate 110 positioned on the lower surface of the first semiconductor layer 131. An upper surface of the second electrode 175 may contact a lower surface of the substrate 110. The second electrode 175 may be ohmically contacted with the substrate 110. Accordingly, a semiconductor device according to one implementation may be formed.

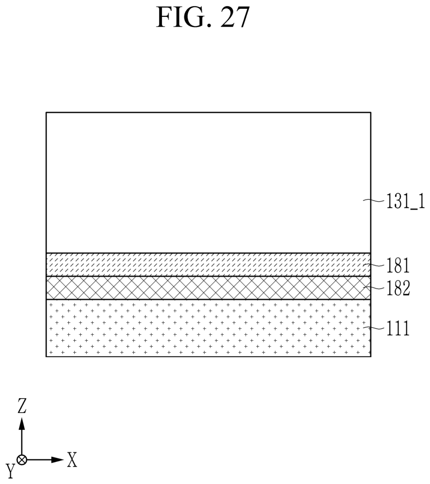

Hereinafter, a method of manufacturing a semiconductor device according to several implementations will be described with reference to FIGS. 27 to 31.

FIGS. 27 to 31 are cross-sectional views of intermediate steps illustrating a method of manufacturing a semiconductor device according to an implementation. FIGS. 27 to 31 illustrate a method for manufacturing the semiconductor device shown in FIGS. 17 to 19.

Referring to FIG. 27, the fourth semiconductor layer 182, the third semiconductor layer 181, and the first semiconductor layer 131_1 may be sequentially formed on the semiconductor substrate 111.

The semiconductor substrate 111 may be a substrate including SiC. For example, the semiconductor substrate 111 may be formed of a 4H SiC substrate. In some cases, the semiconductor substrate 111 may be formed of a 3C SiC substrate, a 6H SiC substrate, and the like. The semiconductor substrate 111 may have a second conductivity type. The semiconductor substrate 111 may be doped with a low concentration with the second conductivity type.

A fourth semiconductor layer 182 may be formed on the semiconductor substrate 111. The fourth semiconductor layer 182 may have a first conductivity type. The fourth semiconductor layer 182 may be doped with a first conductivity type impurity. For example, the first conductivity type impurity may be an n-type impurity. The fourth semiconductor layer 182 may be an epitaxy layer formed by using an epitaxial growth method from the semiconductor substrate 111. The fourth semiconductor layer 182 may include SiC. For example, the fourth semiconductor layer 182 may include 4H SiC.

The third semiconductor layer 181 may be formed on the fourth semiconductor layer 182. The third semiconductor layer 181 may have a second conductivity type. The third semiconductor layer 181 may be doped with a second conductivity type impurity. For example, the second conductivity type impurity may be a p-type impurity. The third semiconductor layer 181 may be an epitaxy layer formed using an epitaxial growth from the fourth semiconductor layer 182. The third semiconductor layer 181 may include SiC. For example, the third semiconductor layer 181 may include 4H SiC.

The first semiconductor layer 131_1 may be formed on the third semiconductor layer 181. The first semiconductor layer 131 may be an epitaxy layer formed using epitaxial growth from the third semiconductor layer 181. The first semiconductor layer 131 may include SiC. For example, the first semiconductor layer 131 may include 4H SiC. The first semiconductor layer 131_1 may have a first conductivity type. The first semiconductor layer 131 may be doped as an n-type.

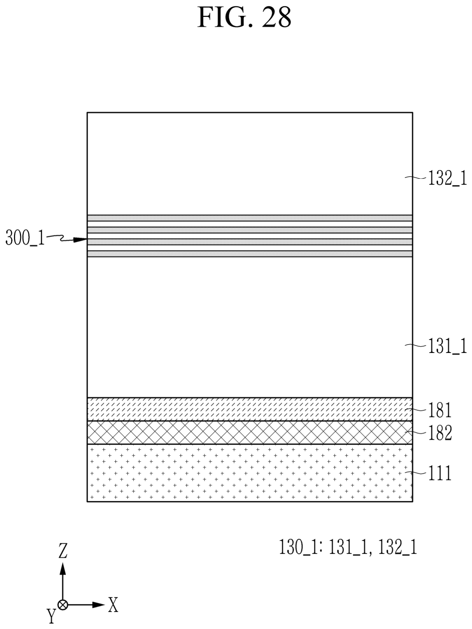

Referring to FIG. 28, a superlattice structure 300_1 including at least one unit superlattice structure may be formed by alternately forming a first superlattice layer and a second superlattice layer on the first semiconductor layer 131_1, and a second semiconductor layer 132_1 may be formed on the superlattice structure 300_1.

The superlattice structure 300_1 may include at least one unit superlattice structure 300_1. For example, the superlattice structure 300_1 may include two or more unit superlattice structures. At least one unit superlattice structure may be stacked on the first semiconductor layer 131_1 in the third direction (Z direction). Accordingly, the superlattice structure 300_1 may have a structure in which unit superlattice structures are stacked repeatedly in the third direction (Z direction). The number of unit superlattice structures may be variously changed.

The superlattice structure 300_1 may be an epitaxy layer formed by epitaxial growth from the first semiconductor layer 131_1. Since the process of forming the superlattice structure 300_1 is substantially the same as the process of forming the superlattice structure 300_1 in the implementation of FIG. 21, the remaining description thereof will be omitted.

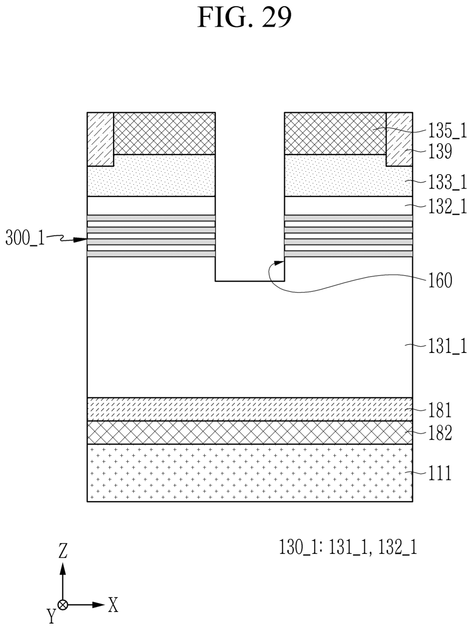

Referring to FIG. 29, first, a doped well region 133 may be formed in the second semiconductor layer 132_1, and a first doped layer 135 and a second doped layer 139 may be formed in the doped well region 133.

Subsequently, a gate trench 160 may be formed penetrating the second semiconductor layer 132_1 and the unit superlattice structure 310_1.

The gate trench 160 may penetrate the second semiconductor layer 132_1 and the unit superlattice structure 310_1. The gate trench 160 may penetrate the first doped layer 135_1, the doped well region 133_1, the second semiconductor layer 132_1, and the superlattice structure 300_1. The gate trench 160 may be positioned within a space in which at least a portion of the first semiconductor layer 131_1 is recessed. The inner wall of the gate trench 160 may be defined by the first doped layer 135_1, the doped well region 133_1, the second semiconductor layer 132_1, the superlattice structure 300_1, and the first semiconductor layer 131_1. A bottom surface of the gate trench 160 may be defined by the first semiconductor layer 131_1.

The gate trench 160 may completely penetrate the superlattice structure 300_1. The distance between the bottom surface of the gate trench 160 and the lower surface of the first semiconductor layer 131_1 may be less than the distance between the lower surface of the superlattice structure 300_1 and the lower surface of the first semiconductor layer 131_1. However, example implementations are not limited thereto, and as in the implementation of FIG. 18, the gate trench 160 may not penetrate the unit superlattice structure 310_1.

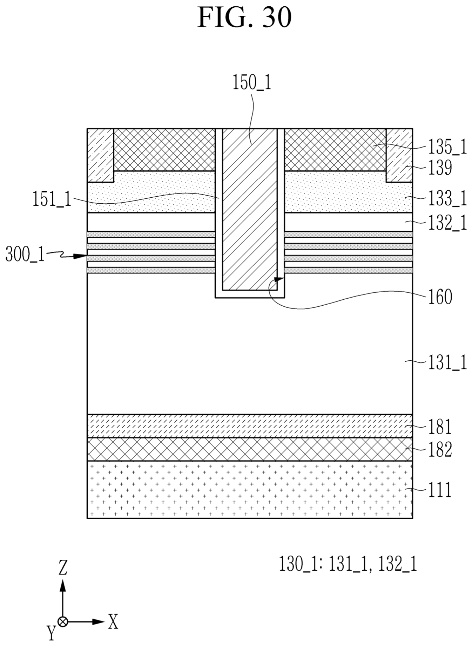

Referring to FIG. 30, a gate insulating layer 151_1 may be formed in the gate trench 160, and a gate electrode 150_1 may be formed.

A gate insulating layer 151_1 may be formed on the inner wall and bottom surface of the gate trench 160. The gate insulating layer 151_1 may be conformally formed on the inner wall and bottom surface of the gate trench 160. The gate insulating layer 151_1 may contact a side surface of the unit superlattice structure 310_1. The gate insulating layer 151_1 may include various insulating materials.

A gate electrode 150_1 may be formed in the gate trench 160 in which the gate insulating layer 151_1 is formed remaining. The gate electrode 150_1 may overlap the superlattice structure 300_1 in the first direction (X direction). The distance between the lower surface of the gate electrode 150_1 and the lower surface of the first semiconductor layer 131_1 may be less than the distance between the lower surface of the superlattice structure 300_1 and the lower surface of the first semiconductor layer 131_1, but is not limited thereto.

Accordingly, the gate insulating layer 151_1 may be positioned between the gate electrode 150_1 and the doped well region 133_1, and between the gate electrode 150_1 and the unit superlattice structure 310_1. In some implementations, the gate insulating layer 151_1 may be positioned between the gate electrode 150_1 and the first semiconductor layer 131_1 and between the gate electrode 150_1 and the second semiconductor layer 132_1.

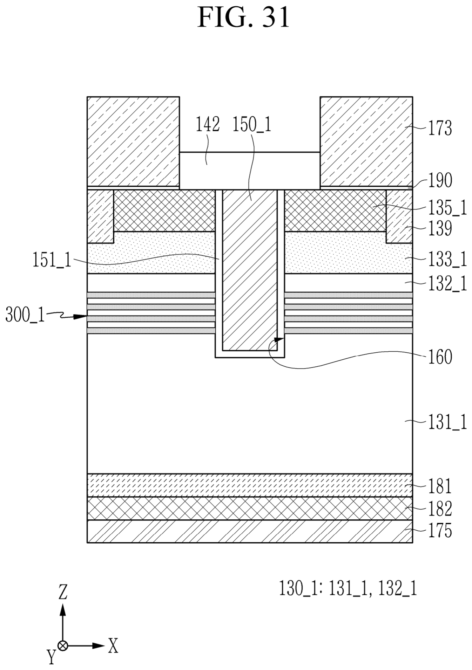

Referring to FIG. 31, a first electrode 173 may be formed on the first doped layer 135_1, and a second electrode 175 may be formed on the lower surface of the first semiconductor layer 131_1.

A method of manufacturing a semiconductor device according to some implementations may further include forming a capping layer 142 on the gate electrode 150_1 prior to forming the first electrode 173.

In some implementations, in the process of forming the first electrode 173, a method of manufacturing a semiconductor device according to some implementations may further include forming a silicide layer 190 on the first doped layer 135_1 and the second doped layer 139.

A second electrode 175 may be formed on the lower surface of a fourth semiconductor layer 182 positioned on the lower surface of the first semiconductor layer 131_1. In some implementations, the method of manufacturing a semiconductor device may further include a step of removing the semiconductor substrate 111 before forming the second electrode 175. However, example implementations are not limited thereto, and the second electrode 175 may be formed on the lower surface of the semiconductor substrate 111 without removing the semiconductor substrate 111.

As used herein, "about," "approximately," "generally," and "substantially" are understood to refer to numbers in a range of numerals, for example the range of -10% to +10% of the referenced number, optionally -5% to +5% of the referenced number, further optionally -1% to +1% of the referenced number, further optionally -0.1% to +0.1% of the referenced number. Moreover, these numerical ranges should be construed as providing support for a claim directed to any number or subset of numbers in that range. For example, a disclosure of from 1 to 10 should be construed as supporting a range of from 1 to 5, from 3 to 6, from 1 to 9, from 2.5 to 4.7, from 2.2 to 9.9, and so forth.

While the present disclosure contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Although example implementations of the present disclosure have been described in detail above, the scope of rights of the present disclosure is not limited thereto, and various modifications and improved forms by those skilled in the art using the basic concept of the present disclosure as defined by the following claims also fall within the scope of rights of the present disclosure.

Embodiments are set out in the following clauses:
Clause 1. A semiconductor device comprising:
   a first semiconductor layer having a first conductivity type,
   at least one unit superlattice structure on the first semiconductor layer,
   a doped well region having a second conductivity type on the at least one unit superlattice structure,
   a first doped layer having the first conductivity type within the doped well region,
   a pillar layer having the second conductivity type within the first semiconductor layer and extending into the at least one unit superlattice structure,
   a gate electrode on the doped well region,
   a gate insulating layer between the doped well region and the gate electrode,
   a first electrode on the first doped layer, and
   a second electrode below a lower surface of the first semiconductor layer,
   wherein the at least one unit superlattice structure includes:
      a first superlattice layer, and
      a second superlattice layer on the first superlattice layer,
   wherein an energy band gap of the first superlattice layer is different from an energy band gap of the first semiconductor layer and an energy band gap of the second superlattice layer.
Clause 2. The semiconductor device of clause 1,
   wherein the at least one unit superlattice structure includes a third superlattice layer below a lower surface of the first superlattice layer, and
   wherein an energy band gap of the third superlattice layer is greater than the energy band gap of the first superlattice layer and less than the energy band gap of the second superlattice layer.
Clause 3. A semiconductor device comprising:
   a first semiconductor layer having a first conductivity type comprising SiC,
   a superlattice structure on the first semiconductor layer, the superlattice structure comprising a first superlattice layer comprising SiC or SiGeC, and a second superlattice layer comprising SiC or SiGeC, the first superlattice layer and the second superlattice layer being alternately stacked,
   a second semiconductor layer on the superlattice structure and comprising SiC,
   a doped well region having a second conductivity type in the second semiconductor layer,
   a first doped layer having the first conductivity type in the doped well region,
   a gate electrode adjacent to the doped well region,
   a gate insulating layer between the doped well region and the gate electrode,
   a first electrode on the first doped layer, and
   a second electrode below a lower surface of the first semiconductor layer,
   wherein an energy band gap of the second superlattice layer is greater than an energy band gap of the first superlattice layer.
Clause 4. The semiconductor device of clause 3,
   wherein a content of C (at%) of the first superlattice layer is less than a content of C (at%) of the second superlattice layer.
Clause 5. The semiconductor device of clause 3 or clause 4,
   wherein the superlattice structure includes a third superlattice layer below a lower surface of the first superlattice layer, and
   wherein an energy band gap of the third superlattice layer is less than the energy band gap of the second superlattice layer.

## Claims

1. A semiconductor device comprising:
a first semiconductor layer (131) having a first conductivity type,
at least one unit superlattice structure (310) on the first semiconductor layer (131),
a second semiconductor layer (132) on the at least one unit superlattice structure (310),
a doped well region (133) having a second conductivity type in the second semiconductor layer (132),
a first doped layer (135) having the first conductivity type in the doped well region (133),
a gate electrode (150) adjacent to the doped well region (133),
a gate insulating layer (151) between the doped well region (133) and the gate electrode (150),
a first electrode (173) on the first doped layer (135), and
a second electrode (175) below a lower surface of the first semiconductor layer (131),
wherein the at least one unit superlattice structure (310) includes:
a first superlattice layer (301), and
a second superlattice layer (302) on the first superlattice layer (301),
wherein an energy band gap of the first superlattice layer (301) is different from an energy band gap of the first semiconductor layer (131).

2. The semiconductor device of claim 1,
wherein the second superlattice layer (302) includes SiC, and
wherein the first superlattice layer (301) includes SiC or SiGeC.

3. The semiconductor device of claim 1 or claim 2, wherein the energy band gap of the first superlattice layer (301) is less than the energy band gap of the first semiconductor layer (131), and an energy band gap of the second superlattice layer (302) is greater than the energy band gap of the first superlattice layer (301).

4. The semiconductor device of claim 3, wherein the energy band gap of the second superlattice layer (302) is the same as the energy band gap of the first semiconductor layer (131) and an energy band gap of the second semiconductor layer (132).

5. The semiconductor device of claim 3 or claim 4,
wherein the second superlattice layer (302) includes SiC,
wherein the first superlattice layer (301) includes SiC or SiGeC, and
wherein a content of C (at%) in the first superlattice layer (301) is less than a content of C (at%) in the second superlattice layer (302).

6. The semiconductor device of any of claims 3-5, wherein the at least one unit superlattice structure (310) includes:
a third superlattice layer (303) below a lower surface of the first superlattice layer (301), and
wherein an energy band gap of the third superlattice layer (303) is greater than the energy band gap of the first superlattice layer (301) and less than the energy band gap of the second superlattice layer (302).

7. The semiconductor device of claim 6,
wherein the second superlattice layer (302) includes SiC,
wherein the third superlattice layer (303) includes SiC or SiGeC, and
wherein a content of C (at%) of the third superlattice layer (303) is less than a content of C (at%) of the second superlattice layer (302).

8. The semiconductor device of claim 1,
wherein the energy band gap of the first superlattice layer (301) is greater than the energy band gap of the first semiconductor layer (131), and
wherein an energy band gap of the second superlattice layer (302) is the same as the energy band gap of the first semiconductor layer (131).

9. The semiconductor device of claim 8,
wherein the at least one unit superlattice structure (310) includes a fourth superlattice layer (304) between the first superlattice layer (301) and the second superlattice layer (302), and
wherein an energy band gap of the fourth superlattice layer is less than the energy band gap of the first superlattice layer and greater than the energy band gap of the second superlattice layer.

10. The semiconductor device of claim 9,
wherein the first superlattice layer (301) and the fourth superlattice layer (304) include SiC, and
wherein a content of Si (at%) of the fourth superlattice layer (304) is greater than a content of Si (at%) of the first superlattice layer (301).

11. The semiconductor device of any preceding claim,
wherein the first semiconductor layer (131) and the second semiconductor layer (132) include a same material, and
wherein the energy band gap of the first semiconductor layer (131) is the same as an energy band gap of the second semiconductor layer (132).

12. The semiconductor device of any preceding claim, comprising
a gate trench (160) extending into the second semiconductor layer (132) and the at least one unit superlattice structure (310),
wherein the gate electrode (150) is in the gate trench (160), and
wherein the gate insulating layer (151) is between the doped well region (133) and the gate electrode (150) and between the at least one unit superlattice structure (310) and the gate electrode (150).

13. The semiconductor device of any of claims 1-11, comprising
a pillar layer (200) having the second conductivity type in the first semiconductor layer (131), and
wherein the pillar layer (200) extends into the at least one unit superlattice structure (310).

14. The semiconductor device of claim 13,
wherein the pillar layer (200) extends from a lower surface of the doped well region (133) toward the second electrode (175).

15. The semiconductor device of claim 13 or claim 14,
wherein a side surface of the pillar layer (200) is in contact with the at least one unit superlattice structure (310).
